# EUROPÄISCHE PATENTSCHRIFT

(11) **EP 3 510 389 B1**
(45) Veröffentlichungstag und Bekanntmachung des Hinweises auf die Patenterteilung: **01.05.2024**
(21) Anmeldenummer: 17780619.7
(22) Anmeldetag: 06.09.2017
(51) Int. Cl.: G01N 27/414, H01L 21/00, H01L 29/00

(54) **VORRICHTUNG BASIEREND AUF EINEM NANODRAHTKREUZ ZUR MESSUNG KLEINER POTENTIALE EINER PROBE, VERFAHREN ZUR HERSTELLUNG DER VORRICHTUNG UND VERWENDUNG DER VORRICHTUNG**
DEVICE BASED ON NANOWIRE CROSSJUNCTION FOR DETECTING SMALL POTENTIALS OF AN ANALYTE, ASSOCIATED FABRICATION METHOD AND USE OF THE DEVICE
DISPOSITIF BASE SUR UNE CROIX DES NANOFILS POUR DETECTER DES PETITS POTENTIELS D'UN ANALYTE, PROCEDE DE FABRICATION ASSOCIE ET UTILISATION DU DISPOSITIF

(30) Priorität: 08.09.2016 DE 102016010764
(43) Veröffentlichungstag der Anmeldung: 17.07.2019
(73) Patentinhaber: Forschungszentrum Jülich GmbH, 52425 Jülich (DE)
(72) Erfinder: VITUSEVICH, Svetlana, 52353 Düren (DE); ZADOROZHNYI, Ihor, 52428 Jülich (DE)
(86) Internationale Anmeldenummer: PCT/DE2017/000286
(87) Internationale Veröffentlichungsnummer: WO 2018/046034

(56) Entgegenhaltungen:
- WO-A2-2012/162271
- JP-A- H02 139 973
- US-A1- 2010 297 608
- SÉBASTIEN R. PLISSARD ET AL: "Formation and electronic properties of InSb nanocrosses", NATURE NANOTECHNOLOGY, Bd. 8, Nr. 11, 13. Oktober 2013 (2013-10-13), Seiten 859-864, XP055422527, GB ISSN: 1748-3387, DOI: 10.1038/nnano.2013.198
- JING LI ET AL: "Sensitivity Enhancement of Si Nanowire Field Effect Transistor Biosensors Using Single Trap Phenomena", NANO LETTERS, Bd. 14, Nr. 6, 11. Juni 2014 (2014-06-11), Seiten 3504-3509, XP055422105, US ISSN: 1530-6984, DOI: 10.1021/nl5010724
- YI CUI ET AL: "Functional nanoscale electronic devices assembled using silicon nanowire building blocks", SCIENCE, AMERICAN ASSOCIATION FOR THE ADVANCEMENT OF SCIENCE, Bd. 291, Nr. 5505, 2. Februar 2001 (2001-02-02), Seiten 851-853, XP002243694, ISSN: 0036-8075, DOI: 10.1126/SCIENCE.291.5505.851
- LIVI PAOLO ET AL: "Sensor system including silicon nanowire ion sensitive FET arrays and CMOS readout", SENSORS AND ACTUATORS B: CHEMICAL: INTERNATIONAL JOURNAL DEVOTED TO RESEARCH AND DEVELOPMENT OF PHYSICAL AND CHEMICAL TRANSDUCERS, ELSEVIER BV, NL, Bd. 204, 15. August 2014 (2014-08-15), Seiten 568-577, XP029070118, ISSN: 0925-4005, DOI: 10.1016/J.SNB.2014.08.002
- SOSHI SATO ET AL: "Effects of corner angle of trapezoidal and triangular channel cross-sections on electrical performance of silicon nanowire field-effect transistors with semi gate-around structure", SOLID STATE ELECTRONICS, Bd. 65, 13. Juli 2011 (2011-07-13), Seiten 2-8, XP028313649, ISSN: 0038-1101, DOI: 10.1016/J.SSE.2011.06.011 [gefunden am 2011-06-22]
- ZA'BAH NOR F ET AL: "Top-down fabrication of single crystal silicon nanowire using optical lithography", JOURNAL OF APPLIED PHYSICS, AMERICAN INSTITUTE OF PHYSICS, US, Bd. 112, Nr. 2, 15. Juli 2012 (2012-07-15) , Seiten 24309-24309, XP012166231, ISSN: 0021-8979, DOI: 10.1063/1.4737463 [gefunden am 2012-07-19]

## Beschreibung

Die Erfindung betrifft eine Vorrichtung zur Messung kleiner Potentiale einer Probe wie in Anspruch 1 definiert, ein Verfahren zur Herstellung der Vorrichtung nach Anspruch 4 und die Verwendung der Vorrichtung (Anspruch 13).

### Stand der Technik

Aus der DE 10 2013 018 850 A1 ist ein Feldeffekt-Transistor bekannt. Dieser umfasst zur Messung kleiner Potentiale von einer Probe ein Source, ein Drain und ein Gate. Das Gate steht mit einer flüssigen Probe in Kontakt. Es ist durch ein Gate-Dielektrikum vom leitenden Kanal des Feldeffekttransistors isoliert. Die Vorrichtung umfasst ferner Mittel zum Anlegen einer Spannung zwischen Source und Drain und Mittel zur Beaufschlagung des Gates mit einer Biasspannung. Im Inneren des Gate-Dielektrikums ist mindestens eine Anlagerstelle angeordnet, die Ladungsträger aus dem Kanal einzufangen und umgekehrt an den Kanal abzugeben vermag. Gemessen werden die lokalen Potentialwerte am Gate.

Aus der US 2010/0297608 A1 ist ein Sensor zur Detektion chemischer und biologischer Substanzen bekannt. Der Sensor umfasst eine in oder auf einem Substrat ausgebildete Halbleiterschicht und einen in der Halbleiterschicht ausgebildeten Kanal mit Abmessungen im Nanobereich, wobei die Struktur einen elektrisch leitenden Pfad zwischen einem ersten Kontakt und einem zweiten Kontakt auf der Halbleiterschicht bildet. Der Kanal im Nanomaßstab kann einen trapezförmigen Querschnitt aufweisen mit einer effektiven Breite und freiliegenden Seitenflächen, wobei die effektive Breite so gewählt ist, dass sie dieselbe Größenordnung hat wie eine Debye-Länge (Ln) des Halbleitermaterials, aus dem die Halbleiterschicht besteht. Substanzen, die auf einem natürlichen Oxid auf der Oberfläche des Nanodrahts angeordnet werden, können detektiert werden.

Nachteilig können Störstellen im Kanal die Messungen verfälschen. Nachteilig lässt sich ferner die Anzahl der Anlagerstellen und deren Positionen nicht genau kontrollieren. Auch dies kann zu ungenauen Messergebnissen führen.

### Aufgabe der Erfindung

Aufgabe der Erfindung ist die Bereitstellung einer Vorrichtung, mit der Änderungen im elektrischen Potential am Gate mit einer besseren Auflösung gemessen werden können als bisher bekannt. Eine weitere Aufgabe ist die Bereitstellung eines Verfahrens zur Herstellung einer solchen Vorrichtung. Ferner ist es eine Aufgabe der Erfindung, Verwendungen für diese Vorrichtung anzugeben.

### Lösung der Aufgabe

Die Aufgabe wird gelöst mit der Vorrichtung nach Patentanspruch 1 und dem Verfahren und der Verwendung gemäß Ansprüchen 4 und 13. Vorteilhafte Ausgestaltungen hierzu ergeben sich gegebenenfalls aus den jeweils hierauf rückbezogenen Patentansprüchen.

### Beschreibung der Erfindung

Die Erfindung betrifft eine Vorrichtung zur Messung kleiner Potentiale einer Probe. Sie umfasst mindestens einen Feldeffekttransistor mit Source, Drain und Gate.

Die Vorrichtung ist dadurch gekennzeichnet, dass sie ein Substrat und mindestens zwei auf diesem Substrat angeordnete sich kreuzende Nanodrähte aus halbleitendem Material mit jeweils einem Source- und Drain-Kontakt mit Mitteln zum Anlegen einer Spannung zwischen dem jeweiligen Source- und Drain-Kontakt aufweist. Dabei weisen die beiden Nanodrähte jeweils im Querschnitt die Form eines Dreiecks auf. An dem Substrat sind Mittel zur Beaufschlagung des Substrats mit einer Spannung angeordnet.

Obwohl in der einfachsten Ausführung der Erfindung von jeweils zwei sich kreuzenden Nanodrähten aus einem halbleitenden Material mit jeweils einem Source- und Drainkontakt und mit Mitteln zum Anlegen einer Spannung zwischen dem jeweiligen Source- und Darin Kontakt gesprochen wird, hat sich im Rahmen der Erfindung herausgestellt, dass es von Vorteil sein kann, wenn die beiden sich kreuzenden Nanodrähte lediglich jeweils zwei Kontakte aufweisen. Diese können, müssen aber nicht zwingend, als Source- und Drainkontakte ausgebildet sein.

Es hat sich hierzu herausgestellt, dass es bei der Verwendung der erfindungsgemäßen Vorrichtung und der Vorrichtung als solches auch von Vorteil sein kann, dass eine Spannung nicht zwischen den beiden Kontakten eines einzigen Nanodrahts angelegt wird, wie es im Fall eines Source- und Drainkontaktes für einen Nanodraht der Fall wäre, sondern wenn eine Spannung auch zwischen einem beliebigen Kontakt des ersten Nanodrahtes und einem weiteren beliebigen Kontakt des zweiten Nanodrahts angelegt werden kann. Dann wird unter sich kreuzenden Nanodrähten verstanden, dass diese zumindest einen gemeinsamen Kontaktpunkt aufweisen, wozu die Nanodrähte vorzugsweise in einer Ebene liegen sollten.

Die Nanodähte sind durch eine dielektrische Schicht entlang ihrer Oberfläche mindestens gegen die Probe elektrisch isoliert wobei in dieser Schicht mindestens eine Anlagerstelle angeordnet ist, welche Ladungsträger aus mindestens einem der beiden Nanodrähte einzufangen und umgekehrt an diesen Nanodraht abzugeben vermag.

Auf der dielektrischen Schicht kann an jedem Nanodraht auf jeder Seite des jeweiligen Nanodrahts um den gemeinsamen Kreuzungsbereich der Nanodrähte ein Plättchen aus Metall angeordnet sein, wobei gegenüberliegende Plättchen jeweils eine Antenne, insbesondere eine bowtie-Antenne, bilden.

Dadurch weist die Vorrichtung ein Substrat und mindestens zwei sich kreuzende Nanodrähte aus halbleitendem Material mit insbesondere jeweils einem Source- und Drain-Kontakt mit Mitteln zum Anlegen einer Spannung zwischen dem jeweiligen Source- und Drain-Kontakt auf. Hierbei sind die Nanodrähte durch eine dielektrische Schicht entlang ihrer Oberfläche mindestens gegen die Probe elektrisch isoliert. In dieser dielektrischen Schicht ist also mindestens eine Anlagerstelle angeordnet, welche Ladungsträger aus mindestens einem der beiden Nanodrähte einzufangen und umgekehrt an diesen Nanodraht abzugeben vermag. Mindestens ein Nanodraht, vorzugsweise beide Nanodrähte, weisen jeweils im Querschnitt die Form eines Dreiecks auf und an dem Substrat sind Mittel zur Beaufschlagung des Substrats mit einer Spannung angeordnet.

Dann wird vorteilhaft bewirkt, dass mindestens ein Nanodraht von einem Strom aus Ladungsträgern, insbesondere Löchern, durchflossen wird, wenn zwischen Source und Drain eine Spannung angelegt wird.

Die Anlagerung von Molekülen aus der flüssigen Probe am Gate beeinflußt die Zeit τ_{c}, mit der eine Anlagerstelle Ladungsträger aus dem Strom in dem Nanodraht einfängt beziehungsweise die Zeit τₑ, mit der sie Ladungsträger wieder in den Nanodraht abgibt. Dies führt vorteilhaft zu einem Wechsel zwischen stärkerem und schwächerem Stromfluss, je nachdem, ob die Anlagerstelle durch ein Loch besetzt ist oder nicht. Durch Messung des Stromsignals, und insbesondere der Zeiten τₑ und τ_{c}, mit denen sich das Stromsignal ändert, welches idealerweise ein Profil in Form von Rechtecken aufweist, lassen sich die elektrischen Eigenschaften, wie zum Beispiel Ladungsverteilungen, von Proben oder Molekülen, insbesondere Biomoleküle, wie zum Beispiel Kardiakbiomoleküle, gut bestimmen.

Die Nanodrähte können neben einem insbesondere gleichschenkligen dreieckigen Querschnitt auch einen trapezförmigen Querschnitt aufweisen. Ein trapezförmiger Querschnitt fällt nicht unter den erfinderischen Gegenstand. Hierdurch wird gegebenenfalls die Anordnung der Anlagerstelle an einer genauen Position des Nanodrahtes erschwert, beispielsweise durch die größere Oberfläche des Nanodrahtes mit einem trapezförmigen Querschnitt im Vergleich zu einem Nanodraht mit einem dreieckigen Querschnitt bei vergleichbarer Seitenlänge.

Sowohl bei einem trapezförmigen als auch bei einem dreieckigen Querschnitt des Nanodrahtes steigt die Anzahl der Anlagerstellen mit der Intensität des verwendeten Lasers.

Das Substrat umfaßt insbesondere die Schichten des Feldeffektransistors, auf denen die Nanodrähte angeordnet sind. Durch die Erhöhung der Spannung an dem Substrat kann vorteilhaft bewirkt werden, dass der Stromfluss, der sich bei niedriger Spannung über den gesamten Querschnitt des Nanodrahts erstreckt, in die Spitze des dreieckigen bzw. trapezförmigen Querschnitts des mindestens einen Nanodrahts verschoben werden kann. Hierdurch wird besonders vorteilhaft bewirkt, dass der Strom auf weniger materialbedingte, verfahrensbedingt nicht vermeidbare Störstellen im Material trifft, welche eine Streuung der Ladungsträger in dem Strom von Source nach Drain verursachen.

Besonders vorteilhaft wird bewirkt, dass der gesamte Stromfluss dabei näher an die Anlagerstellen, das heißt in die Spitze des/der Nanodrähte zur dielektrischen Schicht, verschoben wird. Hierdurch können Potentialwerte an den Anlagerstellen viel empfindlicher gemessen werden als aus dem Stand der Technik bekannt.

Ferner wird ein Übergang von einem dreidimensionalen Stromfluss zu einem eindimensionalen Stromfluss bewirkt. Dadurch werden besonders vorteilhaft mögliche Streuprozesse an materialbedingten Störstellen und damit eine Verfälschung des Signals noch stärker reduziert.

Durch das Anlegen einer geeigneten Spannung an den Nanodrähten kann zudem in einer besonders vorteilhaften Ausführung der Erfindung auch ein Einfangen der Ladungsträger im Kreuzungsbereich der Nanodrähte bewirkt werden, was einem nulldimensionalen Stromfluss entspricht.

Der Feldeffekttransistor umfasst erfindungsgemäß mindestens zwei Nanodrähte, welche sich kreuzen, so dass mindestens ein Abschnitt des einen Nanodrahts auch einen Abschnitt des anderen Nanodrahts umfaßt. Dieser Abschnitt bildet einen Kreuzungsbereich. Eine Anlagerstelle kann gezielt an diesem Kreuzungsbereich angeordnet werden, z. B. mittels eines Lasers.

Dann kann durch das Anlegen einer Spannung an einem ersten Nanodraht ein Strom erzeugt werden und durch Anlegen einer kleineren Spannung an dem zweiten Nanodraht ein Teil des Stroms in diesen zweiten Nanodraht gelenkt werden. Hierdurch läßt sich vorteilhaft der Stromfluss so einstellen, dass er an den Anlagerstellen vorbeifließt, welche verfahrensbedingt nicht genau im Zentrum des Kreuzungsbereichs beziehungsweise gemeinsamen Abschnitts der Nanodrähte liegen, sondern zum Beispiel an einer der seitlichen Oberfläche eines Nanodrahts angeordnet sind.

Der größte Anteil des Stromflusses kann also in der Nähe des Kreuzungsbereichs innerhalb des Querschnitts näher an die Anlagerstelle verschoben werden. Durch den größeren Stromfluss in der Nähe der Anlagerstellen lassen sich Änderungen des Stromflusses und die Einfangzeiten τ_{c} mit größerer Auflösung messen.

In der Regel liegt die Breite L_{side} eines Nanodrahtes in der erfindungsgemäßen Vorrichtung bei 20 nm bis 150 nm, die Höhe L_{hight} bei 20 nm bis 100 nm und die Länge L_{NW} zwischen 100 nm bis 10 µm. Selbstverständlich lassen sich alle Zwischenwerte einstellen.

Die Anlagerstellen haben in einer auf einem Substrat gewachsenen SiO₂ -Schicht typischerweise einen mittleren Abstand von etwa 100 nm, wobei das Substrat ebenfalls SiO₂ umfassen kann. Da sie dem Einfangen und der Abgabe von Ladungsträgern dienen, können sie auch als Fallen von Ladungsträgern, insbesondere einzelner Ladungsträger, betrachtet werden.

Für viele flüssige biologische Proben ist eine Beaufschlagung des Gates und der in dem Gate angeordneten flüssigen Probe mit einer Spannung notwendig, damit der Ladungsaustausch zwischen der Anlagerstelle und dem durch den Nanodraht fließenden Stromfluss stattfindet oder mit erhöhter Frequenz stattfindet. Die Kombination von Gate, insbesondere einer Elektrode, durch welche eine Spannung an die Flüssigkeit angelegt werden kann, und der Flüssigkeit wird auch als "liquid gate" bezeichnet.

Eine besonders vorteilhafte Ausführungsform der Vorrichtung ist dadurch gekennzeichnet, dass auf der dielektrischen Schicht an jedem Nanodraht auf jeder Seite des jeweiligen Nanodrahts um den Kreuzungsbereich ein Plättchen aus Metall angeordnet ist, wobei gegenüberliegende Plättchen jeweils eine Antenne, insbesondere eine bowtie-Antenne, bilden. Zwischen dem Plättchen aus Metall und dem Nandoraht kann eine Schicht aus Titan oder Nickel angeordnet werden, um Diffusionsprozesse zu unterdrücken.

Die Seitenlänge der Plättchen liegt in der Regel bei 50 nm bis 70 nm. Der Abstand zwischen der dem Kreuzungsbereich zugewandten Spitze des dreieckigen Plättchens und der dieser Spitze gegenüberliegenden Seite beträgt ebenfalls in der Regel 50 nm bis 70 nm. Der Abstand zwischen den einander zugewandten Spitzen zweier Plättchen, welche eine bowtie-Antenne bilden, liegt typischerweise bei 10 nm bis 70 nm, wobei wiederum alle Zwischenwerte angenommen werden können.

Vorteilhaft kann hierdurch erreicht werden, dass einfallende Strahlung, insbesondere Laserstrahlung, besser fokussiert werden kann, um die Anlagerstellen zu erzeugen. Hierdurch wird eine gute Positionierung der Anlagerstellen ermöglicht.

Eine Anlagerstelle kann danach gezielt für die Messung an einer gewünschten Position erzeugt oder bei mehreren Anlagerstellen durch deren bekannte Positionen eine Anlagerstelle gezielt ausgewählt werden. Dann kann der Stromfluss in seiner Flußrichtung und Höhe im Querschnitt des Nanodrahts so eingestellt werden, dass er hauptsächlich oder ausschließlich mit dieser Anlagerstelle wechselwirkt. Es kann also als Resultat der Wechselwirkung mit der Anlagerstelle ein Stromsignal ermittelt werden, welches nicht, wie im Stand der Technik, eine Überlagerung der Stromsignale mehrerer Anlagerstellen umfasst. Hierdurch wird ermöglicht, dass die Änderungen zwischen starkem und schwachem Stromsignal und die Zeitpunkte dieser Änderungen und ferner die damit verbundenen Zeitkonstanten mit einer viel größeren Auflösung gemessen werden können.

Die elektromagnetische Strahlung wird in der Mitte einer bowtie-Antenne besonders gut fokussiert, so dass die Anlagerstelle sehr genau an dem Kreuzungsbereich beziehungsweise dessen Zentrum angebracht werden kann. Die Metallplättchen können insbesondere Goldplättchen in einer dreieckigen Form umfassen. Die Oberfläche der Plättchen kann parallel zu der Oberfläche der Nanodrähte verlaufen oder planar geformt sein. Dies hängt von der Dicke der Goldplättchen ab. Wesentlich für die Fokussierung von elektromagnetischer Strahlung ist eine scharfe Spitze der Plättchen in Richtung des Kreuzungsbereichs und eine Seitenlänge der Plättchen von typischerweise 10 nm bis 70 nm, wobei jeder Zwischenwert angenommen werden kann.

Die Wellenlänge der Laserstrahlung kann so gewählt werden, dass die dielektrische Schicht auf der Oberfläche der Nanodrähte, insbesondere die SiO₂ -Schicht, im Hinblick auf die Strahlung transparent ist. Die Wellenlänge der Strahlung kann zum Beispiel bei 785 nm liegen. Der Laserstrahl kann dann an einem Ort an der Zwischenschicht zwischen dem Nanodraht und der dielektrischen Schicht fokussiert werden, so dass genau an der Oberfläche des Nanodrahts eine Anlagerstelle erzeugt wird. Diese kann einen durch den Laser erzeugten Defekt in der Kristallstruktur umfassen.

Bei einer beispielhaften Verwendung einer SiO₂ -Schicht als dielektrische Schicht lassen sich zum Beispiel durch den Laser Sauerstoff-Atome an der Grenzfläche zwischen den Nanodrähten und der dielektrischen Schicht entfernen, so dass ionisierte Silizium-Sauerstoff-Moleküle zurückbleiben. Diese können für verschiedene Anlagerstellen unterschiedliche Ladungszahlen aufweisen, je nachdem, wie viele Sauerstoff-Atome entfernt wurden.

Eine vorteilhafte Ausführungsform der Vorrichtung ist dadurch gekennzeichnet, dass mindestens ein Nanodraht dotiert ist, insbesondere, dass der eine Nanodraht eine andere Dotierung aufweist als ein anderer Nanodraht. Hierdurch kann im Kreuzungsbereich vorteilhaft bewirkt werden, dass mindestens einer der beiden Drähte in mindestens einer Schicht mit einer Höhe von 1 nm bis 5 nm eine andere Dotierungskonzentration oder einen anderen Dotiertyp aufweist als der restliche Nanodraht. Vorteilhaft erfolgt dann der Ladungstransport über einen Tunnelprozess. Es treten dann vorteilhaft besonders scharfe Maxima in der Strom-Spannungskennlinie auf. Hierdurch läßt sich ein im Bereich nahe einem der Maxima gemessener Stromwert besonders gut einem Potentialwert an der Anlagerstelle zuordnen.

In einer vorteilhaften Ausführungsform weist die Vorrichtung in mindestens einem Abschnitt mindestens eines Nanodrahts eine andere Breite und/oder Höhe auf als der Rest dieses Nanodrahts.

Vorteilhaft kann hierdurch erreicht werden, dass der Strom im Bereich der Anlagerstelle eine besonders hohe Änderung seiner Dichte aufweist und sich je nach Ladung der Anlagerstelle besonders stark ändert. Durch die starken Änderungen des Stroms lassen sich die Einfang- und Abgabezeiten an den Anlagerstellen genauer messen.

In einer vorteilhaften Ausführungsform umfasst die Vorrichtung eine Passivierungsschicht für die Zuleitungen und die elektrischen Kontakte. Vorteilhaft schützt eine Passivierungsschicht die elektrischen Kontakte und Zuleitungen vor flüssigen Proben.

Der Bereich des Querschnitts, in welchem der Stromfluss stattfindet, kann vorteilhaft durch die am Gate eingestellte Spannung beeinflußt werden, derart, dass der Stromfluß in Richtung des Substrats verschoben wird. Der Bereich des Querschnitts des Halbleiters, in welchem der Stromfluss stattfindet, wird von der Spitze weg verschoben. Gleichzeitig kann er durch die am Substrat angelegte Spannung von dem unteren Bereich des Nanodrahts weg verschoben werden, welcher der Spitze gegenüber liegt. Der Stromfluss findet dann nur noch in einem schmalen Bereich des Querschnitts des Nanodrahts statt, welcher mit den angelegten Spannungen innerhalb des Querschnitts verschoben werden kann. Hierdurch kann der räumliche Verlauf des Potentials in der Umgebung der Anlagerstelle besser ermittelt werden.

Unter einer Kante, einer Fläche oder einer Struktur soll im Rahmen der Anmeldung insbesondere eine Teilstrecke des Randes der Fläche oder Struktur verstanden werden, durch welche zwei Eckpunkte dieser Fläche miteinander verbunden werden. Unter gegenüberliegenden Kanten der Fläche sollen insbesondere solche Kanten verstanden werden, welche durch eine Achsenspiegelung an der Längsachse oder Symmetrieachse einer achsensymmetrischen Fläche ineinander übergehen. Unter Quadranten sollen insbesondere die vier Abschnitte einer Ebene verstanden werden, welche jeweils durch zwei senkrecht aufeinander stehende Achsen, insbesondere Längsachsen, begrenzt werden. Unter zwei diametralen Punkten sollen insbesondere zwei Punkte verstanden werden, die auf einem Kreis liegen und deren Verbindungsstrecke durch den Mittelpunkt dieses Kreises geht. Entsprechendes soll für diametral gegenüberliegende Kanten, Flächen oder Quadranten gelten.

Ein erfindungsgemäßes Verfahren zur Herstellung einer Vorrichtung zur Messung kleiner Potentiale einer Probe ist in Anspruch 4 definiert.

Das Verfahren weist in einer Ausgestaltung der Erfindung mindestens zwei Ätzschritte unter Verwendung jeweils einer Maske in jedem Ätzschritt auf.

Auf der Oberfläche der Nanodrähte wird eine dielektrische Schicht angeordnet, und in dieser dielektrischen Schicht wird mindestens eine Anlagerstelle angeordnet, welche Ladungsträger aus mindestens einem der beiden Nanodrähte einzufangen und umgekehrt an diesen Nanodraht abzugeben vermag.

Ein Verfahren zur Herstellung einer Vorrichtung zur Messung kleiner Potentiale einer Probe mit mindestens einem Feldeffekttransistor mit Source, Drain und Gate ist dadurch gekennzeichnet, dass das Muster einer Maske auf eine halbleitende Schicht übertragen wird. Nach der Übertragung des Musters der Maske werden in einem anisotropen Ätzprozess, welcher einen, zwei oder mehrere Ätzschritte unter Verwendung jeweils einer Maske in jedem Ätzschritt umfaßt, mindestens zwei sich kreuzende halbleitende Nanodrähte angeordnet werden, auf deren Oberfläche jeweils eine dielektrische Schicht angeordnet ist, und in dieser dielektrischen Schicht mindestens eine Anlagerstelle angeordnet wird, welche Ladungsträger aus mindestens einem der beiden Nanodrähte einzufangen und umgekehrt an diesen Nanodraht abzugeben vermag, wobei die beiden Nanodrähte jeweils im Querschnitt die Form eines Dreiecks oder Trapezes aufweisen. Außerdem werden Source- und Drainkontakte an jedem Nanodraht angeordnet. Weiterhin werden an dem Substrat Mittel zur Beaufschlagung des Substrats mit einer Spannung angeordnet.

Vorteilhaft lassen sich mit dem nach diesem Verfahren hergestellten nanostrukturierten Feldeffekttransistor die elektrischen Eigenschaften von Biomolekülen und flüssigen biologischen Proben mit hoher Auflösung messen.

Ein erfindungsgemäßes Verfahren ist im Übrigen gekennzeichnet durch die Schritte:
a) Auf einem Substrat wird zumindest eine halbleitende Schicht angeordnet.
b) Ein Muster einer virtuellen oder physischen Maske, welches zwei entlang ihrer Längsachse achsensymmetrische Strukturen umfaßt, die sich kreuzen und die jeweils mindestens eine insgesamt oder abschnittsweise rechteckige oder quadratische Form aufweisen, wird bereitgestellt.
c) Es wird mindestens an einer Kante einer Fläche auf der halbleitenden Schicht, welche mit der Gesamtfläche des Musters deckungsgleich ist, Ätzmittel angeordnet, welches das Material der halbleitenden Schicht anisotrop ätzt.
d) Der Schritt c) wird für gegenüberliegende Kanten des Randes der in Schritt c) genannten Fläche wiederholt bis mindestens zwei sich kreuzende Nanodrähte mit dreieckigem oder trapezförmigem Querschnitt entlang der Längsachsen der Fläche angeordnet sind mit einer an jedem Ende des Nanodrahts angeordneten Erhebung für Source beziehungsweise Drain.
e) Entlang der Oberfläche der Nanodrähte wird eine dielektrische Schicht angeordnet.
f) In der dielektrischen Schicht entlang der Oberfläche der Drähte wird mindestens eine Anlagerstelle angeordnet.
g) Die für Drain und Source bestimmten Erhebungen und das Substrat werden mit Mitteln zur Beaufschlagung einer Spannung elektrisch leitend verbunden.

Erfindungsgemäß wurde erkannt, dass durch den in den Schritten a) bis g) aufgeführten Prozess vorteilhaft auch Strukturen mit mehreren Nanodrähten mit dreieckigem Querschnitt erzeugt werden können, welche nicht parallel zueinander stehen. Verfahren zur Erzeugung von Nanodrähten in einer solchen Geometrie aus dem gleichen Material und aus dem gleichen Einkristall sind aus dem Stand der Technik nicht bekannt. Beim anisotropen Ätzen werden verschieden orientierte Kristallebenen verschieden stark und schnell geätzt. Hierdurch können vorteilhaft die gewünschten anisotropen Strukturen erzeugt werden. Die Bezeichnung der Kristallachsen und Kristallebenen wie der {1 0 0}-Ebene erfolgt unter Verwendung der bekannten Millerschen Indizes. Der lithographische Prozess kann zum Aufbringen verschiedener Strukturen mit Photolithographie und/oder mit Elektronenstrahlen durchgeführt werden. So können zum Beispiel die Strukturen für die elektrischen Kontakte mit Photonenstrahlen und für die Nanodrähte mit Elektronenstrahlen angeordnet werden. Zu einer notwendigen Passivierung zum Beispiel der Nanodrähte, Kontakte oder Zuleitungen kann z. B. PI 4525 Passivierungsmaterial verwendet werden, welches mit Alkalin Entwicklern vollständig entfernt werden kann. Dann kann die Struktur in einer sogenannten hard bake procedure gehärtet und stabilisiert werden.

Im Falle der Verwendung von Elektronenstrahlen zur Lithographie, der ebeam Lithographie, wird keine physische Maske sondern eine virtuelle Maske am Computer verwendet. Bei der Maske handelt es sich ebenfalls um ein Muster, welches von den Elektronenstrahlen abgerastert wird. Ein solches Muster kann mit Hilfe von aus dem Stand der Technik bekannten Computerprogrammen erstellt werden.

Zur Erzeugung des Nanodrahtes kann vorteilhaft ein aus dem Stand der Technik nicht bekanntes Verfahren mit mehreren Ätzschritten verwendet werden, bei welchem die Ränder der Fläche, in welcher die mindestens zwei Nanodrähte angeordnet werden sollen, in jedem Ätzschritt nur in diametral gegenüberliegenden Quadranten geätzt werden. Dazu wird in jedem Ätzschritt jeweils eine Maske verwendet, welche jeweils die Gesamtfläche des Musters und zwei weitere Flächen umfasst, welche in diametral entgegengesetzten Quadranten, welche durch die beiden Längsachsen der Gesamtfläche des Musters begrenzt werden, angeordnet sind und zusammen mit der Teilfläche des Musters in dem jeweiligen Quadranten ein Quadrat oder Rechteck bilden.

Vorteilhaft ermöglicht die Anordnung zumindest einer halbleitenden Schicht auf einem Substrat in Schritt a) die Herausbildung von halbleitenden Nanodrähten im Verlaufe des Verfahrens.

Vorteilhaft ermöglicht in Schritt b) die Bereitstellung eines Musters, welches zwei entlang ihrer Längsachse achsensymmetrische Strukturen umfaßt, die sich kreuzen und die jeweils mindestens eine insgesamt oder abschnittsweise rechteckige oder quadratische Form aufweisen, die Anordnung der Nanodrähte in der gewünschten Geometrie im Verlaufe des Verfahrens. Die Längsachsen bilden somit insbesondere die Symmetrieachsen der achsensymmetrischen Strukturen.

Vorteilhaft ermöglicht in Schritt c) die Anordnung eines Ätzmittels, welches das Material der halbleitenden Schicht anisotrop ätzt, an mindestens einer Kante einer Fläche auf der halbleitenden Schicht, welche mit der Gesamtfläche des Musters deckungsgleich ist, dass entlang dieser Kante eine schräge Fläche in die halbleitende Schicht hineingeätzt wird. Dadurch werden Dreiecke Strukturen geätzt. Das Ätzmittel kann hierbei an nur einer, an mehreren oder auch gleichzeitig an allen Kanten angeordnet werden.

Der Ätzprozess kann jeweils maximal so lange durchgeführt werden, bis die obere Kante einer Fläche, welche durch den Ätzprozeß in die halbleitende Schicht hineingeätzt wird, an der Oberfläche der halbleitenden Schicht die Position einer der Längsachsen der in Schritt c) genannten Fläche erreicht.

Vorteilhaft kann durch die Wiederholung des Ätzprozesses gemäß Schritt d) an den Kanten der ersten Fläche die gewünschte Geometrie aus zwei sich kreuzenden Nanodrähten mit dreieckigem oder trapezförmigem Querschnitt entlang der Längsachsen der Fläche und einer an jedem Ende des Nanodrahts angeordneten Erhebung für Source beziehungsweise Drain angeordnet werden. Der Ätzprozess wird gemäß Schritt d) jeweils maximal so lange durchgeführt, bis die obere, von dem Substrat abgewandte Kanten der jeweiligen Flächen, welche durch den Ätzprozess an den gegenüberliegenden Kanten der in Schritt c) genannten Fläche in die halbleitende Schicht hineingeätzt werden, aufeinandertreffen. Nachdem durch den Ätzprozess in einem ersten Schritt zunächst eine Hälfte des Nanodrahtes entlang der jeweiligen Längsachse auf einer Seite angeordnet wird, kann durch Wiederholung des Ätzprozesses in einem zweiten Schritt auf der anderen Seite der Längsachse die zweite Hälfte des Nanodrahtes angeordnet werden.

Gegebenenfalls werden vor der Wiederholung des Ätzprozesses oder der Ätzschritte geeignete Schutz- oder auch Passivierungsschichten oder Resistschichten an den Rändern oder der gesamten Schichtenfolge oder auch an den Kontakten neu angeordnet.

Die in Schritt c) genannten schrägen Flächen werden durch die Ätzprozesse aus entgegengesetzten Richtungen auf die jeweilige Längsachse beziehungsweise Symmetrieachse zubewegt, wenn das Ätzmittel in aufeinanderfolgenden Ätzschritten an gegenüberliegenden Kanten des Randes der ersten Fläche angeordnet wird, bis sich ein Nanodraht mit dem gewünschten dreieckigen Querschnitt ausbildet.

Das Ätzmittel wird zumindest an den Kanten der ersten Fläche angeordnet, welche keine Punkte mit den Längsachsen gemeinsam haben. Das Ätzmittel kann vorteilhaft auch in einem weiteren Bereich der halbleitenden Schicht verwendet werden, welcher nicht innerhalb der ersten Fläche liegt. Dadurch kann die halbleitende Schicht in diesem weiteren Bereich entfernt werden.

Vorteilhaft bewirkt eine Anordnung einer dielektrischen Schicht entlang der Oberfläche der Nanodrähte gemäß Schritt e), dass die Oberfläche der Nanodrähte geschützt wird, beispielsweise vor der flüssigen Probe, die mit der Anordnung untersucht werden soll. Vorteilhaft können in der dielektrischen Schicht Anlagerstellen angeordnet werden.

Vorteilhaft bewirkt eine Anordnung einer Anlagerstelle in der dielektrischen Schicht entlang der Oberfläche der Drähte gemäßt Schritt f), dass die Einfangzeit von Ladungen aus dem Strom durch den Nanodraht durch die Anlagerstelle gemessen werden und so elektrische Eigenschaften der Probe gemessen werden können.

Besonders vorteilhaft bewirkt die elektrisch leitende Verbindung der für Drain und Source bestimmten Erhebungen und dem Substrat mit Mitteln zur Beaufschlagung einer Spannung in Schritt g), dass durch den Nanodraht ein Strom fließen kann.

Ein vorteilhaftes Verfahren ist dadurch gekennzeichnet, dass nach Schritt b) die Anordnung des Ätzmittels gemäß Schritt c) in den folgenden Teilschritten durchgeführt wird:
i) das Ätzmittel wird mindestens an einer ersten Kante der in Schritt c) genannten Fläche angeordnet, wobei mindestens zwischen der Längsachse dieser Fläche, die parallel zu der ersten Kante verläuft, und einer zweiten Kante, die der ersten Kante gegenüberliegt, kein Ätzmittel angeordnet wird,
ii) das Ätzmittel wird entfernt und anschließend mindestens an der zweiten Kante der Fläche angeordnet, wobei mindestens zwischen der Längsachse aus Schritt i) und der ersten Kante kein Ätzmittel angeordnet wird,
iii) der Ätzprozess in den Schritten i) und ii) wird gemäß dem vorher genannten Schritt d) durchgeführt.

Auch durch diese Maßnahme allein wird die Aufgabe der Erfindung gelöst.

Vorteilhaft kann das Ätzmittel gemäß Schritt i) an mindestens einer ersten Kante der ersten Fläche angeordnet werden und gleichzeitig zwischen der gegenüberliegenden Kante und der Längsachse, welche parallel zu der ersten Kante verläuft, nicht angeordnet werden. Vorteilhaft kann der Ätzprozess zur Ätzung einer schrägen Fläche kontrollierter durchgeführt werden, als wenn der gesamte Rand gleichzeitig geätzt wird. Dieser Vorteil entsteht dadurch, dass das Ätzmittel nicht gleichzeitig von verschiedenen Seiten an die zu ätzende Struktur angreift. Außerdem entsteht ein Vorteil dadurch, dass auch die Richtung, in der das Ätzmittel die zu ätzende Struktur angreift, besser kontrolliert werden kann. Insbesondere kann besser kontrolliert werden, entlang welcher Kristallebene der halbleitenden Schicht der Ätzprozess erfolgt.

Gemäß Schritt ii) kann das Ätzmittel, nachdem eine Kante des Randes geätzt wurde, wieder entfernt werden. Wenn zum Beispiel das Ätzmittel an der Kante des Randes angeordnet wurde, indem die Schichtenfolge in das Ätzmittel getaucht wurde, kann das Ätzmittel wieder durch Herausnehmen aus dem Ätzmittel entfernt werden. Anschließend kann das Ätzmittel mindestens an der zweiten Kante des Randes der Fläche angeordnet werden. Hierbei wird mindestens zwischen der Längsachse aus Schritt i) und der ersten Kante kein Ätzmittel angeordnet.

Vorteilhaft wird auf dieselbe Weise wie in Schritt i) eine schräge Fläche in die aktive Schicht geätzt, welche der in Schritt i) geätzten Fläche gegenüberliegt und dieser zugeneigt ist, so dass die beiden Flächen die Randflächen eines Nanodrahtes mit dreieckigem Querschnitt bilden.

Der Ätzprozess an den Kanten der in Schritt c) genannten Fläche wird fortgeführt, bis sich mindestens zwei sich kreuzende Nanodrähte ausbilden.

Es kann zum Beispiel ein Siliziumkristall für die halbleitende Schicht verwendet werden, welcher mit seiner {1 0 0}-Ebene in Richtung der Normalen des Substrats in Richtung der Schichtenfolge orientiert ist. Der Ätzprozess kann mit dem Fachmann bekannten Verfahren in Richtung der Normalen der {1 1 1}-Ebene durchgeführt werden, zum Beispiel mit Hilfe von Masken im Rahmen eines lithographischen Prozesses.

In der Regel findet der Ätzprozess in der (1 1 1)-Kristallebene um etwa einen Faktor 100 langsamer statt als in der (1 0 0)-Ebene, zum Beispiel bei der Verwendung von Tetramethylammoniumhydroxid als Ätzmittel. Bei dem Ätzprozess bildet sich zunächst an jedem Rand, an dem der Ätzprozess durchgeführt wird, eine schräge Fläche aus, deren Normale in die (1 1 1)-Richtung zeigt. Mit zunehmender Zeitdauer des Ätzprozesses wird diese Fläche in das Innere des Bereichs in Richtung der jeweiligen Längsachse verschoben, ohne dass sich die Richtung der Normalen ändert.

Vorteilhaft wird gemäß Schritt iii) beziehungsweise Schritt d) der Ätzprozess jeweils maximal so lange durchgeführt, bis eine Kante dieser in die halbleitende Schicht geätzten Fläche, also insbesondere ihre obere Kante, auf der Höhe der Oberfläche der halbleitenden Schicht die Position einer der Längsachsen der ersten Fläche erreicht, insbesondere der Längsachse, auf die sich die hineingeätzte Fläche durch den Ätzprozess zubewegt.

Der Ätzprozess kann also vorteilhaft mit dem Fachmann bekannten Methoden dann gestoppt werden, zum Beispiel durch Anordnung der Vorrichtung in entionisiertem Wasser, wenn die vom Substrat aus gesehen obere Begrenzungslinie der hineingeätzten schrägen Fläche die Position der jeweiligen Längsachsen der Fläche des gesamten Musters erreicht. Durch die langsame Ätzrate läßt sich der Zeitpunkt, an dem der Ätzprozess gestoppt werden soll, gut kontrollieren.

In einem vorteilhaften Verfahren wird die Anordnung des Ätzmittels in Schritt c) in folgenden Schritten durchgeführt:
i) auf der halbleitenden Schicht wird mindestens eine weitere Schicht angeordnet, welche ein Material umfaßt, welches nach Bestrahlung mit Elektronenstrahlen und/oder Lichtstrahlen und/oder lonenstrahlen entfernt werden kann,
ii) es wird eine Maske bereitgestellt, welche zumindest eine Fläche aufweist, die mit der Gesamtfläche des Musters übereinstimmt,
iii) die weitere Schicht wird mit Elektronenstrahlen und/oder Licht und/oder lonenstrahlen durch eine der Masken bestrahlt,
iv) die Bereiche der weiteren Schicht, welche durch die Maske hindurch bestrahlt wurden, werden entfernt,
v) das Ätzmittel wird zumindest auf der Oberfläche der halbleitenden Schicht auf der Fläche unterhalb der entfernten Bereiche der weiteren Schicht angeordnet,
vi) das Verfahren wird gemäß dem vorgenannten Schritt d) fortgeführt, wobei das Ätzmittel an den Kanten der in Schritt c) genannten Fläche jeweils nach Verwendung einer Maske gemäß Schritt ii) zur Bestrahlung angeordnet wird.

Vorteilhaft ermöglicht die Anordnung einer weiteren Schicht auf der halbleitenden Schicht gemäß Schritt i), welche ein Material umfaßt, welches nach Bestrahlung mit Elektronenstrahlen und/oder Lichtstrahlen und/oder lonenstrahlen entfernt werden kann, den Schutz ausgewählter Bereiche der halbleitenden Schicht vor dem Ätzmittel im weiteren Verfahren.

Vorteilhaft ermöglicht die Bereitstellung einer Maske in Schritt ii), welche zumindest eine Fläche aufweist, die mit der Gesamtfläche des Musters übereinstimmt, den Schutz der entsprechenden Oberfläche der weiteren Schicht vor der Bestrahlung im weiteren Verfahren.

Vorteilhaft ermöglicht die Bestrahlung der weiteren Schicht mit Elektronenstrahlen und/oder Licht und/oder lonenstrahlen durch die Maske , dass sich die bestrahlten Bereiche von den nicht bestrahlten chemisch oder physikalisch unterscheiden und im weiteren Verfahren entfernt werden können.

Vorteilhaft werden durch die Entfernung der bestrahlten Bereiche der weiteren Schicht die darunterliegenden Bereiche der halbleitenden Schicht freigelegt, welche im weiteren Verfahren entfernt werden können, um die gewünschte Geometrie der Nanodrähte in der halbleitenden Schicht anzuordnen.

Vorteilhaft werden durch Anordnung des Ätzmittels zumindest auf der Oberfläche der halbleitenden Schicht diese Bereiche entfernt. Durch Anordnung des Ätzmittels entlang aller Kanten gemäß Schritt vi) werden die Nanodrähte mit dreieckigem Querschnitt in die halbleitende Schicht geätzt.

In einem besonders vorteilhaften Verfahren wird eine Maske bereitgestellt, welche jeweils die Gesamtfläche des Musters und zwei weitere Flächen umfasst, welche in diametral entgegengesetzten Quadranten, welche durch die beiden Längsachsen der Gesamtfläche des Musters begrenzt werden, angeordnet sind und zusammen mit der Teilfläche des Musters in dem jeweiligen Quadranten ein Quadrat oder Rechteck bilden.

Eine solche Maske ist aus dem Stand der Technik nicht bekannt. Bei Verwendung einer solchen Maske werden in zwei diametral gegenüberliegenden Quadranten die Kanten einer Fläche auf der weiteren Schicht, welche mit der Fläche des Musters übereinstimmt, nicht bestrahlt. Die Quadranten sind durch die Längsachsen dieser Fläche begrenzt. An diesen Kanten wird dann auch die auf der halbleitenden Schicht angeordnete weitere Schicht nach der Bestrahlung nicht entfernt. Das Ätzmittel greift dann die halbleitende Schicht entlang dieser Kante also nicht an. Die halbleitende Schicht wird also nur entlang der Kanten angegriffen, welche diesen durch die weitere Schicht geschützten Kanten diametral gegenüberliegen. Dann wird der Bereich, in welchen die Nanodrähte hineingeätzt werden sollen, nicht an zwei gegenüberliegenden Kanten gleichzeitig angegriffen, also an zwei Teilstrecken des Randes, welche durch eine Achsenspiegelung an der jeweiligen Längs- beziehungsweise Symmetrieachse ineinander übergehen. Der Ätzprozess kann also kontrollierter durchgeführt werden, als wenn der Bereich von zwei Seiten gleichzeitig geätzt wird.

In einem nächsten Schritt gemäß dem vorgenannten Schritt vi) bzw. dem vorgenannten Schritt d) kann eine Maske des gleichen Typs verwendet werden, durch welche die Bereiche der weiteren Schicht in den anderen beiden diametral gegenüberliegenden Quadranten bestrahlt werden. Nach Entfernung dieser Bereiche sind die übrigen Kanten dem Ätzmittel zugänglich, welche den Kanten aus dem vorherigen Bestrahlungs- und Ätzschritt gegenüberliegen. Durch Anordnung des Ätzmittels an diesen Kanten können dann die Nanodrähte in die halbleitende Schicht geätzt werden.

Eine weitere Ausgestaltung des Verfahrens ist dadurch gekennzeichnet, dass die bereitgestellte Maske jeweils die Gesamtfläche des Musters und drei weitere Flächen umfasst, welche in jeweils einem Quadranten, welche durch die beiden Längsachsen der Gesamtfläche des Musters begrenzt werden, angeordnet sind und zusammen mit der Teilfläche des Musters in dem jeweiligen Quadranten ein Quadrat oder Rechteck bilden.

Vorteilhaft wird der Bereich der halbleitenden Schicht außerhalb des Bereichs, in welchen die Nanodrähte geätzt werden sollen, bei Verwendung einer solchen Maske nur in einem Quadranten bestrahlt. Der bestrahlte Bereich kann anschließend entfernt werden. Es wird dann nur die Kante der ersten Fläche in diesem Quadranten dem Ätzmittel zugänglich. Dies ermöglicht vorteilhaft einen noch besser kontrollierten Ätzprozess.

Durch Verwendung von vier Masken dieses Typs können die Teilbereiche des Randes der ersten Fläche in allen vier Quadranten dem Ätzmittel zugänglich gemacht werden und die Nanodrähte in die halbleitende Schicht hineingeätzt werden.

Ein vorteilhaftes Verfahren ist dadurch gekennzeichnet, dass auf die dielektrische Schicht auf der Oberfläche jedes Nanodrahts Plättchen aus Metall, insbesondere Goldplättchen, aufgedampft werden.

Vorteilhaft wird durch das Aufdampfen der Metallplättchen die Struktur der Oberfläche des Nanodrahts nicht zerstört. Aufgedampfte Metallplättchen sind vorteilhaft ausreichend, um einfallende Strahlung zur Erzeugung von Anlagerstellen zu fokussieren. Insbesondere können hierzu Goldplättchen verwendet werden, welche eine dreieckige Form aufweisen, wobei gegenüberliegende Goldplättchen eine Antenne, insbesondere eine bowtie-Antenne, bilden.

Ein vorteilhaftes Verfahren ist dadurch gekennzeichnet, dass mindestens eine der rechteckigen Strukturen in dem Muster der verwendeten Maske in verschiedenen Abschnitten verschiedene Breiten aufweist.

Vorteilhaft bewirkt die Verwendung von rechteckigen Strukturen in dem Muster der Maske mit verschiedenen Breiten bei der Bestrahlung der Fotolackschicht, dass die Fläche, in welcher der Draht angeordnet werden soll, in der Richtung von Source nach Drain in verschiedenen Abschnitten verschiedene Breiten aufweist.

Vorteilhaft können dann im Ätzprozess Abschnitte des Nanodrahts mit verschiedenen Höhen oder Breiten erzeugt werden. Die Höhe des Nanodrahts wird unter anderem durch die Breite der Fläche bestimmt, welche mit dem Ätzmittel in Kontakt gebracht wird, also in welcher der Draht angeordnet werden soll. Insbesondere kann von den mindestens zwei Nanodrähten der eine Nanodraht eine andere Höhe und Breite aufweisen als der andere Nanodraht.

Eine vorteilhafte Verwendung ist dadurch gekennzeichnet, dass aus der Zeitkonstanten τ_{c} oder der Zeitkonstanten τₑ der pH-Wert der Probe ermittelt wird.

Die Zeitkonstante τ_{c} oder Zeitkonstante τₑ kann direkt aus dem Zeitintervall, in welchem der Drainstrom den maximalen oder minimalen Wert annimmt, bestimmt werden. Aus diesen Zeitkonstanten lassen sich die Änderungen der Werte des lokalen Potentials an der Oberfläche der dielektrischen Schicht angeben. Die Abhängigkeit der Zeitkonstanten von dem lokalen Potential werden durch den Abstand der Störstelle von der Oberfläche des jeweiligen Nanodrahts beeinflußt. Dieser Abstand kann Werte zwischen 0,2 nm und 2 nm annehmen. Dieser kleine Abstand und eine genaue Positionierung der Störstelle läßt sich durch die Verwendung der bowtie-Antennen erreichen. Die elektrischen Eigenschaften der jeweiligen Probe und ihr pH-Wert läßt sich aus Änderungen des vorgenannten lokalen Potentials bestimmen.

Die Vorrichtung kann dazu verwendet werden, aus der Zeitkonstante τ_{c} oder aus der sogenannten Grenzfrequenz f₀ =1/τ_{c} +1/τₑ den pH-Wert der Probe zu ermitteln.

Die Grenzfrequenz ist hierbei in Übereinstimmung mit der DE 10 2013 018 850 A1 die größte Frequenz, mit der das Stromsignal gerade noch übertragen werden kann. Der pH-Wert ist direkt mit den elektrischen Eigenschaften von zum Beispiel Biomolekülen, organischen Molekülen oder Bioflüssigkeiten korreliert, die sich am Gate des Feldeffekttransistors anlagern und dort zum lokalen Potential beitragen. Der pH-Wert und andere elektrische Eigenschaften oder Potentiale einer Probe können direkt aus dem Verhalten des Drainstroms und insbesondere der Zeitkonstante τ_{c} bestimmt werden.

Der pH-Wert kann somit aus Messwerten für das Potential ausgewertet werden. Es handelt sich bei dem pH-Wert um eine elektrische Größe der Probe. Wenn der pH-Wert die einzige im konkreten Anwendungsfall interessierende Eigenschaft der Probe ist, kann auch an Hand von Testproben mit definiertem pH-Wert eine direkte Kalibrierung vorgenommen werden, die jeder Zeitkonstanten τ_{c} beziehungsweise jeder Grenzfrequenz f₀ genau einen pH-Wert zuordnet. Auf der Basis einer solchen Kalibrierung kann der pH-Wert ohne Umweg über eine Spannung oder ein Potential direkt aus τ_{c} oder aus f₀ ausgewertet werden.

Die Vorrichtung kann dazu verwendet werden, die Zeitkonstante τ_{c} für das Einfangen von Ladungsträgern oder die Zeitkonstante τₑ für das Abgeben von Ladungsträgern durch die Anlagerstelle zu messen.

Bei der Vorrichtung kann das Signal nur einer Anlagerstelle gemessen werden, deren Position bekannt ist. Der Stromfluss läßt sich in die Nähe der Anlagerstelle bewegen. Durch die erfindungsgemäße Vorrichtung wird daher ein Signal mit besserer Auflösung gemessen als bei aus dem Stand der Technik bekannten Vorrichtungen.

Der Stromfluss kann derart eingestellt werden, dass die Streuung nur durch die Einfangstelle verursacht wird.

Hierzu kann der Stromfluss durch eine geeignete Spannung am Substrat so eingestellt werden, dass er nur noch in der Spitze des Nanodrahtes stattfindet. In der Spitze des Nanodrahts findet der Stromfluss dann fast ohne Streuung statt, das heißt es tritt ein quasiballistischer Transport der Ladungsträger auf. Die Streuung der Ladungsträger in dem Stromfluß wird dann hauptsächlich durch die Anlagerstelle beziehungsweise Einfangstelle bestimmt. Hierdurch weist der Stromfluss weniger Rauschen auf.

Zur verbesserten Unterdrückung von Streueffekten kann die Breite des Kreuzungsbereichs der Nanodrähte insbesondere vorteilhaft vergleichbar mit der Streulänge der Ladungsträger in den Nanodrähten gewählt werden. Diese Streulänge kann z. B. bei etwa 50 nm liegen. Eine vorteilhafte Verwendung der Vorrichtung ist dadurch gekennzeichnet, dass sie zur Diagnose von Krebszellen eingesetzt wird.

An dem erfindungsgemäßen Feldeffefkttransistor können zur Erkennung von Krebszellen Antikörper angeordnet werden. Die Gewebe- oder Blutprobe mit den Tumorzellen von Darmkrebspatienten kann als Zelllösung aufbereitet werden, die über die erfindungsgemäße Vorrichtung fließen kann. Vorteilhaft können die Antigene der Krebszellen an die Antikörper binden. Dadurch verändert sich das Oberflächenpotenzial am Gate der erfindungsgemäßen Vorrichtung, was zu einer veränderten Stromstärke im Nanodraht-Transistor führt.

Eine vorteilhafte (nicht Gegenstand der Erfindung) Verwendung der Vorrichtung ist dadurch gekennzeichnet, dass sie in der Quanteninformationstechnologie zur Speicherung von Information verwendet wird. Die neue kreuzförmige Geometrie des Sensors lässt sich auch für Ansätze zur Verwendung quantenmechanischer Vorgänge in der Informationstechnologie verwenden, zum Beispiel, indem der Zustand der Falle, wenn sie eine Ladung eingefangen hat, als "1" und der Zustand der Falle ohne eingefange Ladung als "0" gewertet wird. Durch die Vorrichtung kann also Information gespeichert werden.

Zur Ätzung kann im allgemeinen ein Ätzmittel verwendet werden, welches Tetramethylammoniumhydroxid (TMAH) oder Kaliumhydroxid (KHO) umfasst.

Beim Ätzen können mit TMAH unterschiedliche anisotrope Strukturen geformt werden. Jedes andere zum anisotropen Ätzen geeignete Ätzmittel kann ebenfalls verwendet werden. Hierbei können an den Oberflächen der Nanodrähte auf einer Skala von etwa 0,5 nm bis 5 nm flache Ebenen ausgebildet werden.

Die mindestens eine Anlagerstelle kann mit Hilfe von Laserlicht erzeugt werden.

Laserstrahlen können durch die Antennen so fokussiert werden, dass der Strahl nur noch einen Durchmesser von 10 nm bis 70 nm aufweist. Mit Hilfe von Laserlicht können also Anlagerstellen an genau bestimmten Positionen erzeugt oder auch wieder entfernt werden, zum Beispiel durch einen aus dem Stand der Technik bekannten Glühprozess, auch als Annealing-Prozess bezeichnet.

Mindestens ein Nanodraht kann dotiert werden. Insbesondere kann der eine Nanodraht mit einer anderen Dotierung versehen werden als der andere Nanodraht.

Vorzugsweise kann eine Dotierung der Nanodrähte durch eine gegebenenfalls unterschiedliche Dotierung der jeweiligen Source- und Drain-Kontakte erzielt werden. Bei dieser Dotierungsmethode werden keine weiteren Fehlstellen, zum Beispiel in den Nanodrähten, erzeugt. Alternativ kann die halbleitende Schicht, aus welcher die Nanodrähte geätzt werden, vor dem Ätzprozess in unterschiedlichen Bereichen unterschiedlich dotiert werden.

Es können auch Netzwerke bereitgestellt werden, welche mindestens zwei Kreuzungsbereiche aufweisen, welche durch mindestens einen Nanodraht miteinander verbunden sind. Hierbei kann der erste Kreuzungsbereich eine andere Anlagerstelle aufweisen als der zweite Kreuzungsbereich, zum Beispiel in Form von Silizium-Sauerstoff-Atomen oder Silizium-Sauerstoff-Ionen unterschiedlicher Ladungszahl. Hierdurch läßt sich das gemessene Stromsignale modulieren. Zum Beispiel läßt sich ein Stromsignal erzeugen, welches sich in einem Zeitintervall von dem maximalen auf den minimalen Wert ändert, wobei die Amplitude des Signals innerhalb dieses Zeitintervalls ebenfalls zwischen zwei unterschiedlichen Werten wechselt.

Die Meßergebnisse der Änderungen des Potentials durch die Anlagerung von Molekülen hängen unter anderem von den Eigenschaften der Anlagerstelle ab, wie die Einfangzeiten, die Aktivierungsenergie, also die zur Messung notwendige in der Flüssigkeit angelegte Spannung, ab der der Ladungsaustausch zwischen der Anlagerstelle und dem durch den Nanodraht fließenden Stromfluss stattfindet, dem Querschnitt des jeweiligen Nanodrahtes, der Position der Anlagerstelle, der Abhängigkeit des Stroms von charakteristischen Zeiten wie den Einfang- und Abgabezeiten und auch von den Spannungen an dem Gate und an dem Substrat. Die jeweiligen optimalen Werte können mit dem Fachmann bekannten Mitteln festgestellt werden.

Die charakteristischen Größen des Nanodrahts, wie zum Beispiel seine Breite und Höhe, können mit dem Fachmann bekannten Mitteln so angepasst werden, dass die Messergebnisse nur durch eine Anlagerstelle bestimmt werden.

Zur Passivierung des erfindungsgemäßen Transistors kann zum Beispiel PI 4525 Passivierungsmaterial verwendet werden, welches mit Alkalin Entwicklern vollständig entfernt werden kann, zum Beispiel an den Bondflächen zur Außenkontaktierung der Mittel zur Beaufschlagung von Spannung, bevor die Struktur in einer sogenannten hard bake procedure gehärtet wird. Die Passivierung der Mittel zur Beaufschlagung von Spannung betrifft insbesondere auch eine Passivierung von Zuleitungen gegen Flüssigkeiten wie Elektrolytlösungen, welche untersucht werden sollen.

Anschließend wird in einer vorteilhaften Ausführugnsform des erfindungsgemäßen Verfahrens eine flüssigkeitsdichte Umrandung auf der aktiven Siliziumschicht angeordnet, welche zum Beispiel PI 4525 umfasst und die Kontakte und Zuleitungen schützen und isolieren kann. Ferner werden passivierte Mittel zur Beaufschlagung einer Flüssigkeit mit Spannung innerhalb dieser Umrandung bereitgestellt. Diese Mittel können zum Beispiel eine Elektrode umfassen, welche in eine zu untersuchende Flüssigkeit eingetaucht werden kann und mit einer Spannungsquelle verbunden ist. Dadurch wird ein "liquid gate" angeordnet.

Anschließend wird eine Lösung mit Biomolekülen, zum Beispiel das aus dem Stand der Technik bekannte Troponin (Tn), hinzugegeben und der Transistor mit dieser Lösung in Kontakt gebracht beziehungsweise in diese hineingetaucht.

Danach werden Drain und Gate mit Spannungen in einem optimierten Regime in der I-V-Kennlinie des Transistors beaufschlagt. Der am Drain-Kontakt gemessene Strom hängt hierbei von der in der Flüsigkeit angelegten Spannung ab.

In einem anschließenden Schritt werden die Zeitabhängigkeiten der Änderungen des Drain-Stromes gemessen.

In einem folgenden Schritt werden die Einfangzeiten der Ladungen an der Anlagerstelle aus den Daten zur Strommessung bestimmt. Die Einfangzeiten τ_{c} werden für verschiedene pH-Werte der flüssigen Probe gemessen. Hierzu kann die Konzentration der Protonen in der Flüssigkeit durch dem Fachmann bekannte Methoden geändert werden. Es kann auch ein Histogramm erstellt werden, in welchem dargestellt wird, wie häufig der Strom von Source nach Drain bestimmte Stromwerte annimmt. Dies ergibt eine Aussage darüber, wie schnell sich der Strom ändert. Hierdurch kann auch auf die Einfangzeit geschlossen werden.

In einem nächsten Schritt wird das biologische Objekt identifiziert, indem die gemessenen Daten analysiert werden und mit Kalibrationskurven verglichen werden.

Durch Anlegen einer Vorspannung an dem Substrat, also einer geeigneten back gate Spannung, kann eine geeignete Anlagerstelle ausgewählt werden, um ein verstärktes Signal der Potentialänderung durch die Anlagerung von Biomolekülen zu messen.

Eine optimierte Spannung am Gate und lokale elektrische Felder können verwendet werden, um den Effekt der Stromänderung zu verstärken und genauer messen zu können. Hierdurch kann die Abhängigkeit der Einfangzeit von der Stromstärke I von I⁻¹ auf I⁻¹⁵ verändert werden. Die Sensitivität kann um eine Größenordnung verbessert werden im Vergleich zu aus dem Stand der Technik bekannten Biosensoren. Durch die Messung der Änderungen des Stromflusses, welche durch die Änderungen des Potentials im Gate-Bereich durch die Biomoleküle hervorgerufen werden, kann dann der Biosensor, welcher den Feldeffekttransistor umfasst, wesentlich empfindlicher gestaltet werden als bisher bekannt.

Diese Struktur kann auch auf eine größere Anzahl von Nanodrähten, welche mehrere Kreuzungsbereiche beziehungsweise gemeinsame Abschnitte aufweisen, ausgedehnt werden. Hierbei können auch mehrere Anlagerstellen angeordnet werden, zum Beispiel an jedem Kreuzungsbereich eine, welches jeweils eine spezifische Einfangzeit und Abgabezeit aufweisen. Dann können im Spektrum des Stromsignals mehrere Zeitkonstanten enthalten sein.

Wenn die Breite der Bereiche, in welchen die Nanodrähte angeordnet werden sollen, für die Nanodrähte jeweils verschieden gewählt werden, so können die Nanodrähte nach dem Ätzprozess verschiedene Höhen aufweisen. Auch die Bereiche innerhalb der Nanodrähte, in denen sich die Ladungsträger bewegen, können dann bei einer aufgeschalteten Spannung am Substrat auf verschiedenen Höhen liegen. Durch geeignete Spannungen an Substrat und Gate ist ein Umschalten des Stromflusses von dreidimensional auf eindimensional oder nulldimensional möglich.

Das hier dargestellte Verfahren zur Herstellung des Feldeffekttransistors zur Messung kleiner Potentiale ist kompatibel mit der CMOS-Technologie.

### Ausführungsbeispiele

Nachfolgend wird der Gegenstand der Erfindung anhand von Beispielen und Figuren näher erläutert. Diese sind nicht einschränkend zu verstehen. Darin wird ein Verfahren zur Herstellung eines erfindungsgemäßen Feldeffekttransistors mit mindestens zwei sich kreuzenden Nanodrähten und dessen Verwendung angegeben.

Hierzu werden die folgenden Schritte durchgeführt:
In einem ersten Schritt wird ein Silicon-On-Insulator wafer oxidiert, wobei eine SiO₂ -Schicht auf einer Silizium-Schicht erzeugt wird.

Die SiO₂ -Schicht kann hierbei dadurch erzeugt werden, dass das Silizium-Substrat beziehungsweise der Wafer oxidiert wird. Die Oxidation geschieht bei einer Temperatur von etwa 1000 °C für eine Zeitdauer von 30 min. Danach hat die Si-Schicht eine Dicke von etwa 50 nm. Die Dicke der SiO₂ - Schicht beträgt etwa 5 bis 40 nm. Die {1 0 0}-Ebene des Siliziumkristalls ist dabei vorteilhaft in Richtung der Normalen des Substrats in Richtung der Schichtstruktur orientiert. Das Substrat kann eine Silizium-Schicht und eine auf dieser Silizium-Schicht angeordnete isolierende Schicht umfassen. Auf dieser isolierenden Schicht kann die aktive Silizium-Schicht angeordnet werden.

Auf der SiO₂ -Schicht werden anschließend durch ein lithographisches Verfahren die Bereiche definiert, in welchen mindestens zwei sich überkreuzende Nanodrähte angeordnet werden sollen sowie Bereiche für den jeweiligen Source- und Drain-Kontakt an den Nanodrähten.

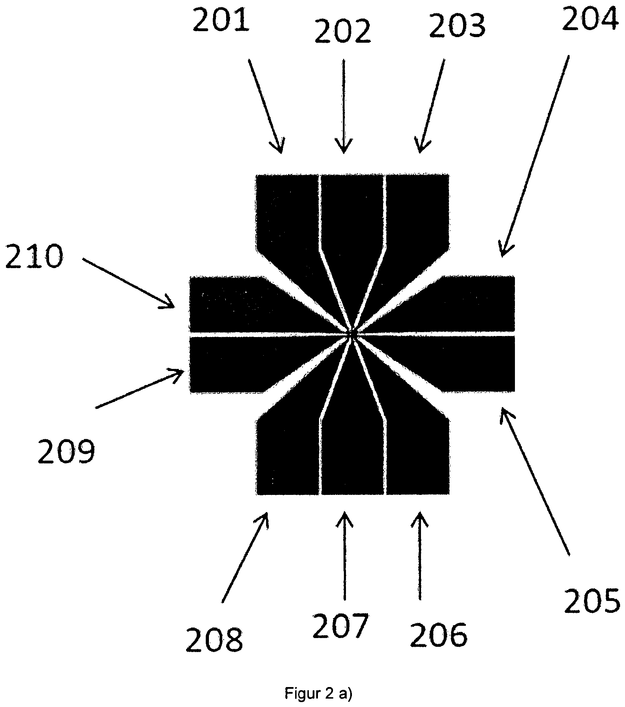

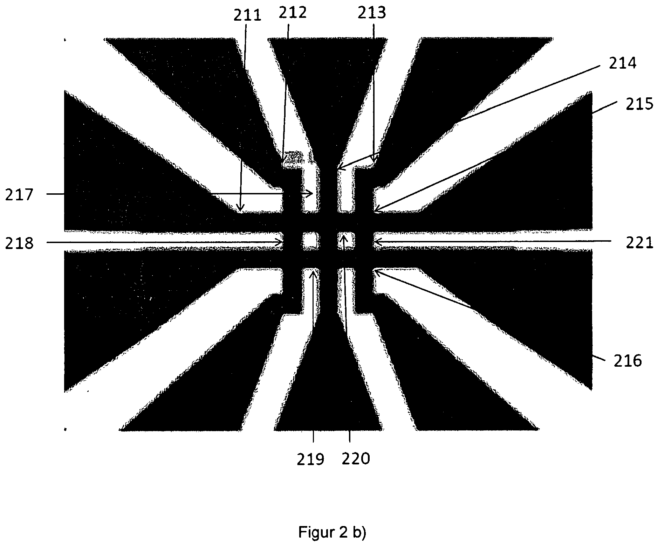

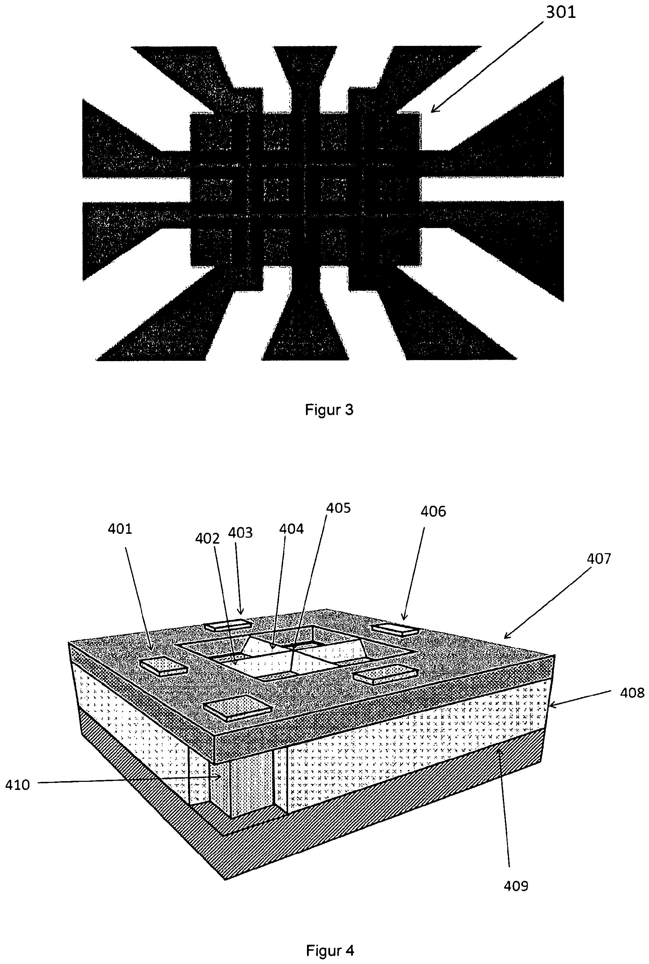

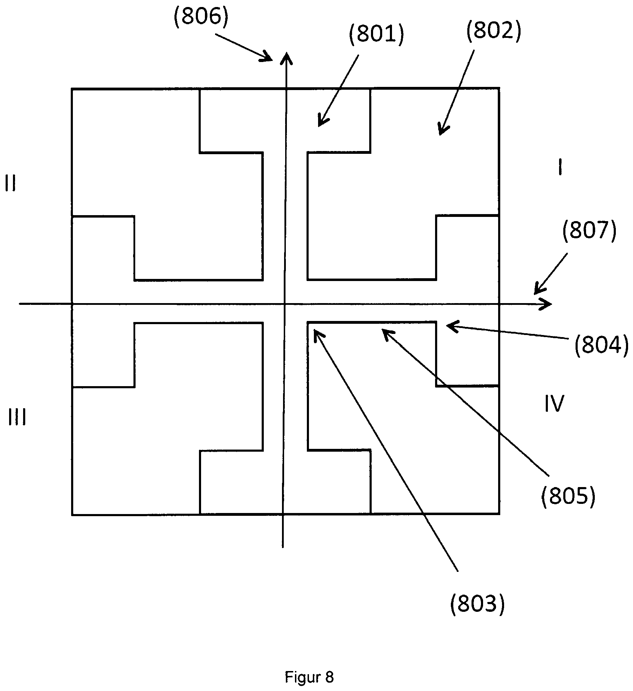

Eine mögliche Geometrie umfasst zwei Nanodrähte, die in einem Winkel von etwa 90° zueinander stehen. Eine Maske umfassend ein Muster für zwei derartige Nanodrähte mit mindestens zwei entlang ihrer Längsachse achsensymmetrischen Strukturen, welche sich in einem Winkel von 90° kreuzen und welche jeweils mindestens eine insgesamt oder abschnittsweise rechteckige oder quadratische Form aufweisen, siehe Figur 8, kann hierzu vorteilhaft so orientiert werden, dass bei einer der Strukturen zwei Seiten jedes rechteckigen Abschnitts parallel zu dem Flat eines wafers verlaufen. Bei dem Flat des Wafers handelt es sich bekanntermaßen um eine gerade Kante an der Seite des Wafers, welche der Ausrichtung des Wafers und seiner Kristallstruktur dient. Es können auch andere Geometrien definiert werden, zum Beispiel zwei breitere Drähte und drei dünnere Drähte, welche einen gemeinsamen Kreuzungsbereich mit sechs Kreuzungspunkten aufweisen, siehe Figuren 2 und 3.

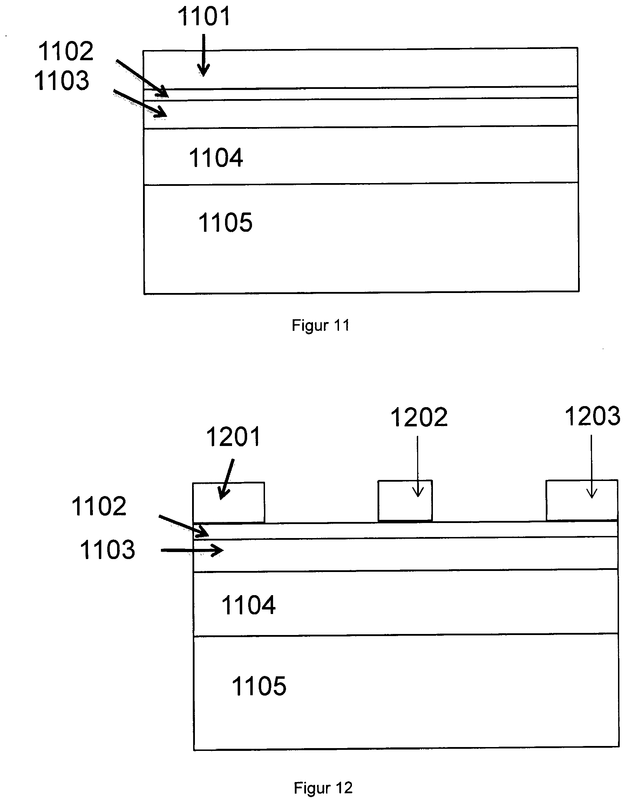

Auf der aktiven Si-Schicht beziehungsweise auf der SiO₂ -Schicht wird ein Fotolack oder auch ein Resist für Elektronenstrahlen angeordnet. Die gesamte Schichtenfolge ist in Figur 11 dargestellt.

Danach wird die Maske zwischen dem beschichteten Substrat und der Licht- oder Elektronenstrahlquelle angeordnet. Durch eine anschließende Bestrahlung der Fotolackschicht aus dieser Quelle wird das Muster der Maske auf die Fotolackschicht übertragen. Hierdurch wird eine Fläche ausgezeichnet, welche mit dem Muster der Maske übereinstimmt. Eine durch das Muster der Maske bestimmte Fläche wird also durch die Übertragung auf dem Fotolack definiert.

Bei dem lithographischen Prozess kann Fotolithographie unter Verwendung von Lichtstrahlen zur Strukturierung der Kontakte oder Elektronenstrahllithographie unter Verwendung von Elektronenstrahlen zur Strukturierung der Bereiche verwendet werden, in welchen die Nanodrähte angeordnet werden sollen. Zur Strukturierung der Kontakte können auch die bekannten Verfahren der nano-imprint-Technologie verwendet werden. Bei der Kombination von optischer Lithographie und Elektronenstrahllithographie kann zunächst die optische Lithographie mit Hilfe eines geeigneten Fotolacks durchgeführt werden und anschließend der Fotolack entfernt und die Elektronenstrahllithographie durchgeführt werden.

Anschließend werden die Bereiche der Fotolackschicht außerhalb einer Fläche, welche mit dem Muster der Maske übereinstimmt, also der durch das Muster der Maske definierten Fläche, durch aus dem Stand der Technik bekannte Verfahren entfernt, siehe Figur 12.

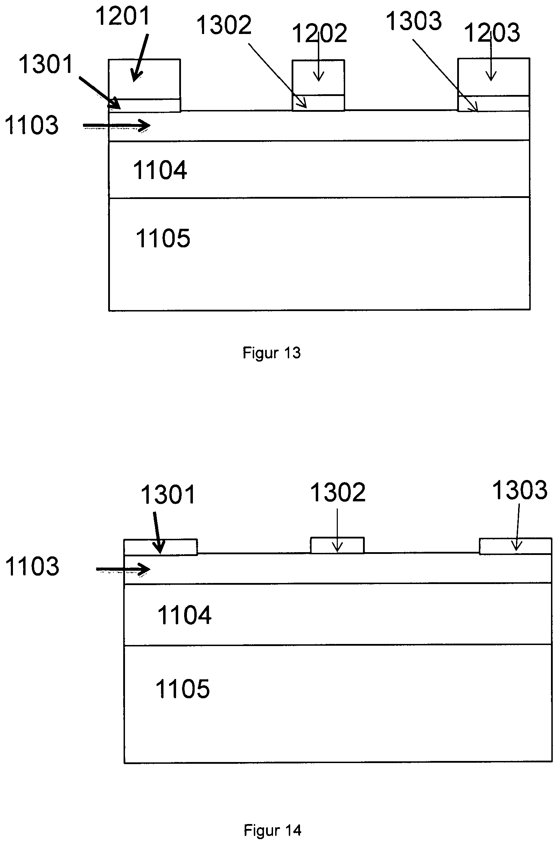

Nun werden die Bereiche der SiO₂ - Schicht außerhalb der durch das Muster der Maske definierten Fläche durch aus dem Stand der Technik bekannte Verfahren entfernt. Dies kann zum Beispiel durch bekannte Verfahren des Trockenätzens geschehen, zum Beispiel Materialabtrag durch Beschuss mit Teilchen wie Ionen, z. B. mit P, As oder B. Auch der Fotolack wird entfernt, siehe Figur 13.

In einem nächsten Schritt wird die aktive Si-Schicht beziehungsweise deren restliche Bereiche, welche innerhalb der mit dem Musters der Maske übereinstimmenden Fläche angeordnet sind, nach Entfernung des restlichen Fotolacks beziehungsweise Elektronenstrahl-Resists, siehe Figur 14, nasschemisch anisotrop geätzt. Dieser Prozess wird genügend lange durchgeführt, dass sich Nanodrähte mit dreieckigem Querschnitt herausbilden, welche sich bei einem Winkel von 90° kreuzen, sowie Erhebungen für die Source- und Drain-Kontakte, siehe Figur 15. Die restlichen Bereiche der SiO₂ - Schicht können ebenfalls durch dem Fachmann bekannte Methoden entfernt werden, siehe Figur 16.

Zur Ätzung kann in einer Mischung 5 % Tetramethylammoniumhydroxid (TMAH) und 95 % destilliertes Wasser bei einer Temperatur von 80 °C verwendet werden. Der Siliziumkristall ist hierbei mit seiner <1 0 0>-Richtung in Richtung der Normalen der Oberfläche des Substrats orientiert. Die Ätzrate für die Kristallebenen in (1 1 1)-Richtung beträgt 13 nm/min. Durch das TMAH werden Kristallebenen, welche in (1 1 1)-Richtung orientiert sind, langsamer geätzt als zum Beispiel die in (1 0 0)-Richtung orientierten Ebenen. Es bilden sich Nanodrähte mit dreieckigem Querschnitt und fast flachen Kristallebenen bei einem Winkel von 54,7° aus für eine Zeitdauer von 15 Sekunden bis 10 Minuten.

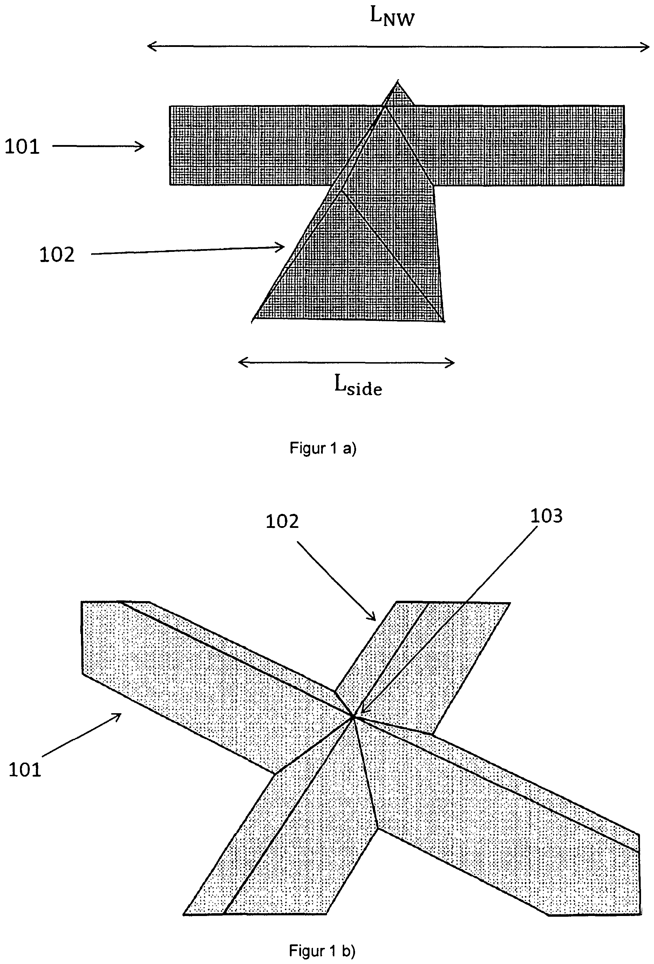

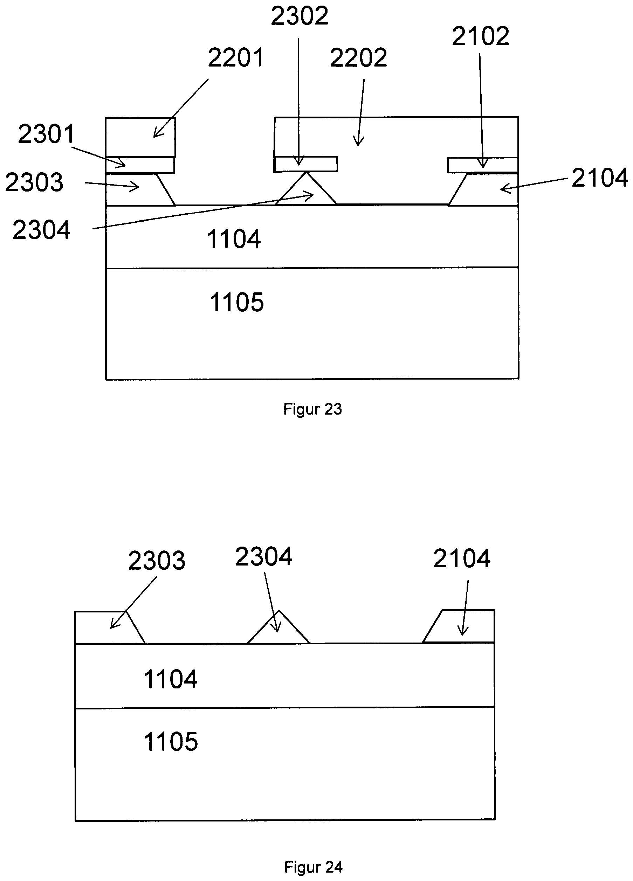

Der durch das Verfahren hergestellte erfindungsgemäße Transistor mit mindestens zwei sich kreuzenden Nanodrähten, siehe Figuren 1, 5 und 6, ist in Figur 4 und im Querschnitt in Figur 24 dargestellt.

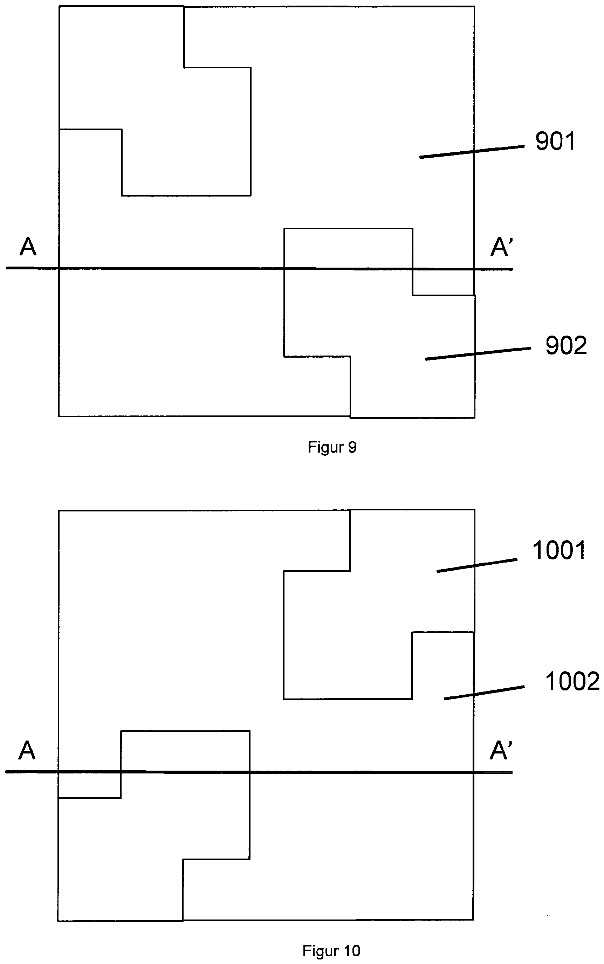

Alternativ kann für die Bestrahlung eine erste Maske verwendet werden, welche jeweils die Gesamtfläche des Musters und zwei weiteren Fläche umfasst, welche in diametral entgegengesetzten Quadranten, welche durch die beiden Längsachsen der Gesamtfläche des Musters begrenzt werden, angeordnet sind und zusammen mit der Teilfläche des Musters in dem jeweiligen Quadranten ein Quadrat oder Rechteck bilden, siehe Figur 9.

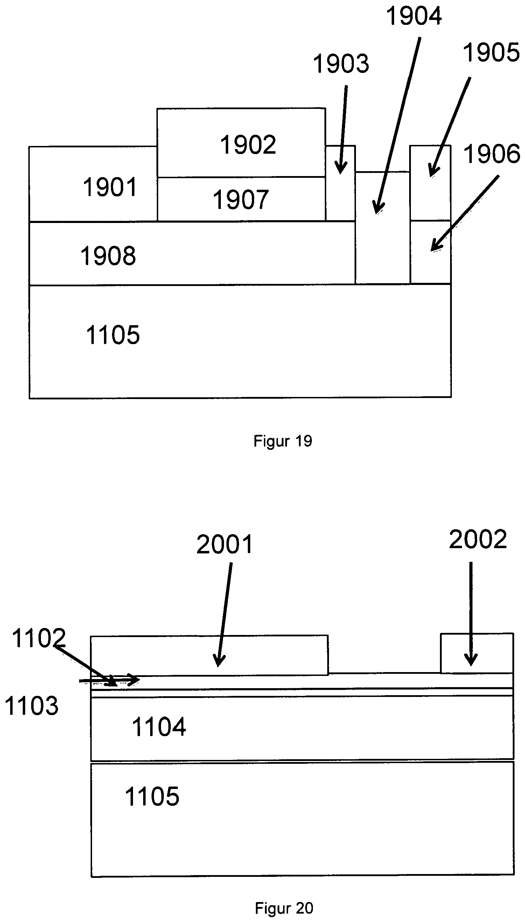

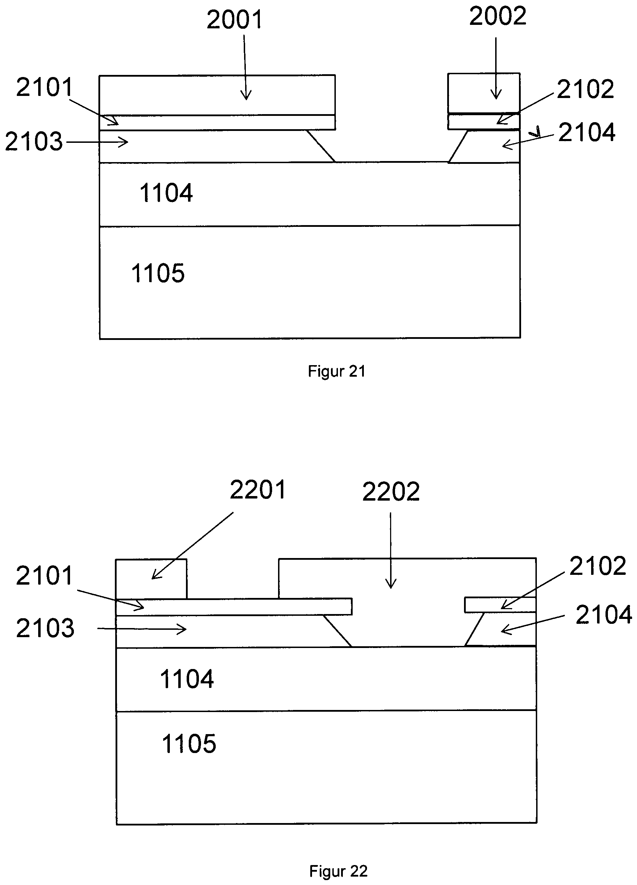

Bei Verwendung einer solchen Maske werden in zwei diametral gegenüberliegenden Quadranten die Kanten der Fläche auf dem Fotolack oder der Siliziumdioxidschicht, welche mit der Fläche des Musters übereinstimmt, nicht bestrahlt. Die nicht bestrahlten Bereiche des Fotolacks und der Siliziumdioxidschicht werden dann in einem Entwicklungsschritt auch nicht entfernt, siehe Figur 20. Dementsprechend greift dann auch das Ätzmittel an diesen Kanten nicht an. Daher wird der Bereich, in welchen die Nanodrähte hineingeätzt werden sollen, nicht an zwei gegenüberliegenden Kanten gleichzeitig angegriffen, siehe Figur 21. Der Ätzprozess kann also kontrollierter durchgeführt werden, als wenn der Bereich von zwei Seiten gleichzeitig geätzt wird.

Anschließend kann eine zweite Maske des gleichen Typs verwendet werden, um die Bereiche der Fotolackschicht beziehungsweise Siliziumdioxidschicht oder der weiteren Schutzschichten, welche weggeätzt werden sollen, in den Quadranten zu bestrahlen, welche bei Verwendung der ersten Maske noch nicht bestrahlt wurden. Dies sind die beiden anderen diametral genüberliegenden Quadranten, siehe Figur 10. Nach Entfernung dieser Bereiche sind die übrigen Kanten des Bereichs, in welchen die Nanodrähte hineingeätzt werden sollen, dem Ätzmittel zugänglich, welche den Kanten aus dem vorherigen Bestrahlungs- und Ätzschritt gegenüberliegen. Durch Anordnung des Ätzmittels an diesen Kanten können dann die Nanodrähte in die halbleitende Schicht geätzt werden, siehe Figur 23. Die unter Verwendung der ersten Maske geätzten Bereiche können hierbei durch Anordnung eines Fotolacks oder Resists geschützt werden, siehe Figur 22.

Alternativ kann ferner eine Maske vewendet werden, welche jeweils die Gesamtfläche des Musters und drei weiteren Flächen umfasst, welche in jeweils einem Quadranten, welche durch die beiden Längsachsen der Gesamtfläche des Musters begrenzt werden, angeordnet sind und zusammen mit der Teilfläche des Musters in dem jeweiligen Quadranten ein Quadrat oder Rechteck bilden.

Bei Verwendung einer solchen Maske werden nur an einem Quadranten die Kanten der Fläche auf dem Fotolack oder der Siliziumdioxidschicht, welche mit der Fläche des Musters übereinstimmt, bestrahlt. Die übrigen Kanten werden bei Anwendung des Ätzmittels von diesem nicht angegriffen. Dies erlaubt eine noch bessere Kontrolle des Ätzprozesses. Durch Verwendung von vier Masken dieses Typs können in aufeinanderfolgenden Ätzschritten alle Kanten des Bereichs, in welchem die Nanodrähte angeordnet werden sollen, geätzt werden.

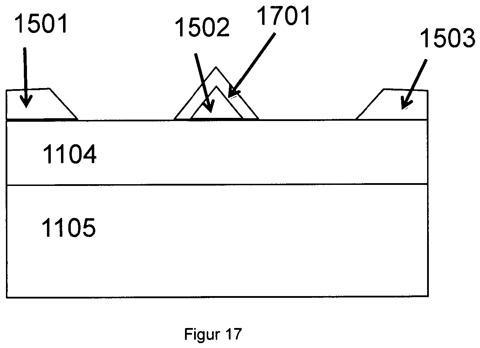

Anschließend wird durch thermische Oxidation eine neue SiO₂-Schicht entlang der Oberflächen der Nanodrähte als dielektrische Schicht mit einer Dicke im Bereich von 5 nm bis 40 nm angeordnet, siehe Figur 17.

In einem nächsten Schritt werden Source, Drain und Gate gebildet.

Die für den Source- und Drain-Kontakt bestimmten Erhebungen können vorteilhaft zunächst dotiert werden mit einer Dotierkonzentration von 5·10¹⁹cm⁻³ bis 5·10²⁰cm⁻³.

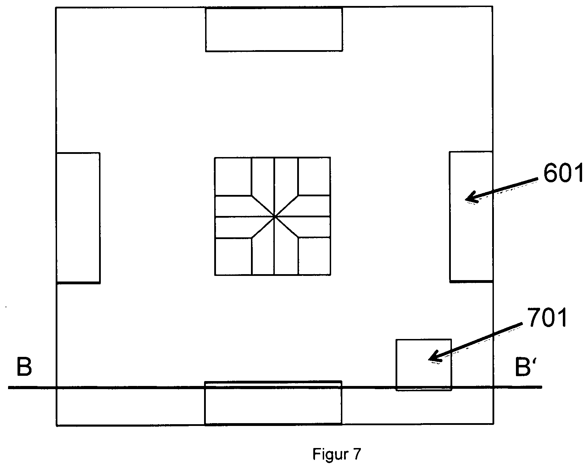

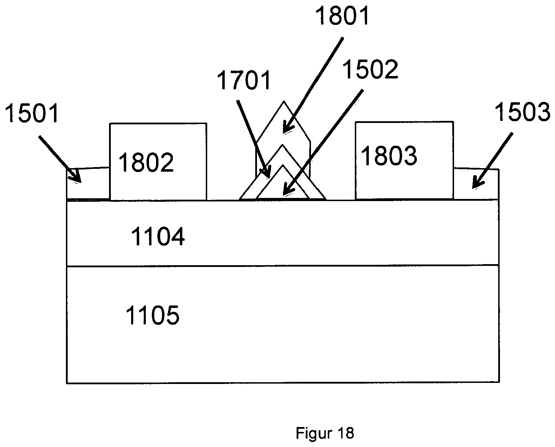

Anschließend werden Metallplättchen, zum Beispiel Goldplättchen, an den für den Source- und Drain-Kontakt bestimmten Erhebungen angeordnet, siehe Figur 18. Zusätzlich kann zum Beispiel eine Titan-Schicht zwischen den Metallplätchen und den Erhebungen zur Vermeidung von Diffusionsprozessen angeordnet werden. Die Erhebungen können so mit dem jeweiligen Nanodraht und einer Spannungsquelle elektrisch leitend verbunden werden. Zum Beispiel kann an einer Ecke oder auf der Rückseite des Substrats die aktive Siliziumschicht entfernt werden und ein Metallblock als Gate, beziehungsweise als back gate, angeordnet sowie mit einer Spannungsquelle elektrisch kontaktiert werden, siehe Figur 4 und Figur 19, in welcher der Metallblock im Querschnitt entlang der in Figur 7 gezeigten Linie BB' dargestellt ist. Das Substrat kann somit mit Mitteln zur Beaufschlagung mit einer Spannung elektrisch leitend kontaktiert werden.

In der SiO₂ -Schicht beziehungsweise der dielektrischen Schicht auf den Nanodrähten wird mindestens eine Anlagerstelle in einem Abstand von vorteilhaft maximal 2 nm zur Oberfläche der Nanodrähte angeordnet.

Zur Bildung der Anlagerstellen können Metallplättchen, zum Beispiel die vorgenannten Goldplättchen, auf die dielektrische Schicht oberhalb der Nanodrähte um den Kreuzungsbereich aufgedampft werden, mit einer Dicke von zum Beispiel 5 nm bis 40 nm. Diese Metallplättchen bilden die Bestandteile einer Antenne, insbesondere einer bowtie-Antenne. Hierdurch können Laserstrahlen auf das Zentrum des Kreuzungsbereichs der Nanodrähte fokussiert werden.

Die Metallplättchen der bowtie-Antennen weisen typischerweise einen Abstand von 50 nm auf, wobei die maximale Breite der Metallplättchen 60 nm beträgt. Die Strukturen der Metallplättchen, insbesondere Goldplättchen, können unter Verwendung von Elektronenstrahllithographie aufgetragen werden. Insbesondere können vier Metallplättchen so angeordnet werden, dass auf der dielektrischen Schicht an jedem Nanodraht auf jeder Seite des jeweiligen Nanodrahts um den gemeinsamen Kreuzungsbereich der Nanodrähte ein Plättchen aus Metall angeordnet ist, wobei gegenüberliegende Plättchen jeweils eine Antenne bilden.

Durch die Antennen läßt sich einfallende elektromagnetische Strahlung, insbesondere Laserstrahlung, auf einen gewünschten Punkt fokussieren und damit gezielt an einem Ort eine Anlagerstelle erzeugen. Dabei kann es sich zum Beispiel um das Zentrum des Kreuzungsbereichs der beiden Nanodrähte handeln. Es können auch an mehreren Orten gezielt Anlagerstellen erzeugt werden. Begrenzt wird die Genauigkeit insbesondere durch den Durchmesser des Laserstrahls.

Die Dichte der Anlagerstellen läßt sich durch die Lichtintensität des Lasers bei einer Wellenlänge von zum Beispiel 785 nm steuern, wodurch das elektrische Feld in der dielektrischen Schicht lokal verändert wird. So können Anlagerstellen oder Defekte lokal gebildet oder entfernt werden, zum Beispiel durch einen Glühprozess, auch als Annealing-Prozess bezeichnet. Die dielektrische Schicht beziehungsweise SiO₂ -Schicht auf den Nanodrähten ist hierbei vorteilhaft gegenüber der Laserstrahlung transparent. Dann können die Anlagerstellen genau an der Zwischenschicht zwischen der Silizium-Schicht und der SiO₂ -Schicht des Nanodrahtes erzeugt werden, zum Beispiel durch Entfernen von Sauerstoff-Atomen aus der SiO₂ - Schicht.

Danach werden die Mittel zur Beaufschlagung von Spannung an dem Drain-, Source- und Gate-Kontakt und die Oberflächen der Nanodrähte, an denen keine SiO₂ -Schicht angeordnet ist, passiviert, siehe Figur 18.

Hierzu kann zum Beispiel PI 4525 Passivierungsmaterial verwendet werden, welches mit Alkalin Entwicklern vollständig entfernt werden kann, zum Beispiel an den Bondflächen zur Außenkontaktierung der Mittel zur Beaufschlagung von Spannung, bevor die Struktur in einer sogenannten hard bake procedure gehärtet wird. Die Passivierung der Mittel zur Beaufschlagung von Spannung betrifft insbesondere auch eine Passivierung von Zuleitungen gegen Flüssigkeiten wie Elektrolytlösungen, welche untersucht werden sollen.

Anschließend wird eine flüssigkeitsdichte Umrandung auf der aktiven Siliziumschicht angeordnet, welche zum Beispiel PI 4525 umfasst und die Kontakte und Zuleitungen schützen und isolieren kann. Ferner werden passivierte Mittel zur Beaufschlagung einer Flüssigkeit mit Spannung innerhalb dieser Umrandung bereitgestellt. Diese Mittel können zum Beispiel eine Elektrode umfassen, welche in eine zu untersuchende Flüssigkeit eingetaucht werden kann und mit einer Spannungsquelle verbunden ist. Dadurch wird ein "liquid gate" angeordnet.

In einem weiteren Schritt wird eine Lösung mit Biomolekülen, zum Beispiel aus dem Stand der Technik bekannte kohlenstoffreaktive Proteine (CRP) oder Troponin (Tn), hinzugegeben.

In einem weiteren Schritt werden Drain und Gate mit Spannungen in einem optimierten Regime in der I-V-Kennlinie des Transistors beaufschlagt. Der am Drain-Kontakt gemessene Strom hängt hierbei von der in der Flüsigkeit angelegten Spannung ab.

In einem anschließenden Schritt werden die Zeitabhängigkeiten der Änderungen des Drain-Stromes gemessen.

In einem folgenden Schritt werden die Einfangzeiten der Ladungen an der Anlagerstelle aus den Daten zur Strommessung bestimmt. Die Einfangzeiten τ_{c} werden für verschiedene pH-Werte der flüssigen Probe gemessen. Hierzu kann die Konzentration der Protonen in der Flüssigkeit durch dem Fachmann bekannte Methoden geändert werden. Es kann auch ein Histogramm erstellt werden, in welchem dargestellt wird, wie häufig der Strom von Source nach Drain bestimmte Stromwerte annimmt. Dies ergibt eine Aussage darüber, wie schnell sich der Strom ändert. Hierdurch kann auch auf die Einfangzeit geschlossen werden.

In einem nächsten Schritt wird das biologische Objekt identifiziert, indem die gemessenen Daten analysiert werden und mit Kalibrationskurven verglichen werden.

Durch Anlegen einer Vorspannung an dem Substrat, also einer geeigneten back gate Spannung, kann eine geeignete Anlagerstelle ausgewählt werden, um ein verstärktes Signal der Potentialänderung durch die Anlagerung von Biomolekülen zu messen.

Eine optimierte Spannung am Gate und lokale elektrische Felder können verwendet werden, um den Effekt der Stromänderung zu verstärken und genauer messen zu können. Hierdurch kann die Abhängigkeit der Einfangzeit von der Stromstärke I von I⁻¹ auf I⁻¹⁵ verändert werden. Die Sensitivität kann um eine Größenordnung verbessert werden im Vergleich zu aus dem Stand der Technik bekannten Biosensoren. Durch die Messung der Änderungen des Stromflusses, welche durch die Änderungen des Potentials im Gate-Bereich durch die Biomoleküle hervorgerufen werden, kann dann der Biosensor, welcher den Feldeffekttransistor umfasst, wesentlich empfindlicher gestaltet werden als bisher bekannt.

Diese Struktur kann auch auf eine größere Anzahl von Nanodrähten, welche mehrere Kreuzungsbereiche beziehungsweise gemeinsame Abschnitte aufweisen, ausgedehnt werden.

Wenn die Breite der Bereiche, in welchen die Nanodrähte angeordnet werden sollen, für die Nanodrähte jeweils verschieden gewählt werden, so können die Nanodrähte nach dem Ätzprozess verschiedene Höhen aufweisen. Auch die Bereiche innerhalb der Nanodrähte, in denen sich die Ladungsträger bewegen, können dann bei einer aufgeschalteten Spannung am Substrat auf verschiedenen Höhen liegen. Durch geeignete Spannungen an Substrat und Gate ist ein Umschalten des Stromflusses von dreidimensional auf eindimensional oder nulldimensional möglich.

Das hier dargestellte Verfahren zur Herstellung des Feldeffekttransistors zur Messung kleiner Potentiale ist kompatibel mit der CMOS-Technologie.

Nachfolgend wird der Gegenstand der Erfindung anhand von Figuren näher erläutert, ohne dass der Gegenstand der Erfindung dadurch beschränkt wird.

Es ist gezeigt:
- Figur 1:: Aktiver Bereich des Feldeffekttransistors.
- Figur 2:: Beispiel einer Mesa-Struktur mit fünf Nanodrähten mit gemeinsamen Kreuzungsbereich.
- Figur 3:: Maske zur Erzeugung der Nanodrähte mit gemeinsamen Kreuzungsbereich.
- Figur 4:: Feldeffekttransistor mit zwei Nanodrähte mit gemeinsamen Kreuzungsbereich.

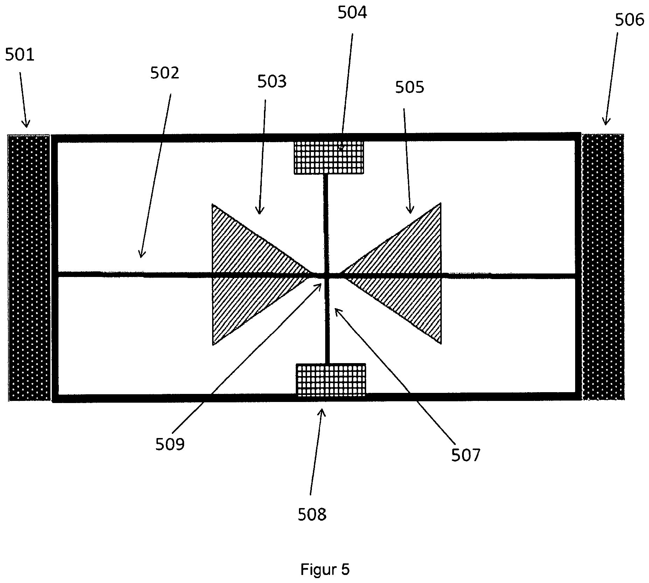

- Figur 5:: Aufsicht auf zwei Nanodrähte mit gemeinsamen Kreuzungsbereich.

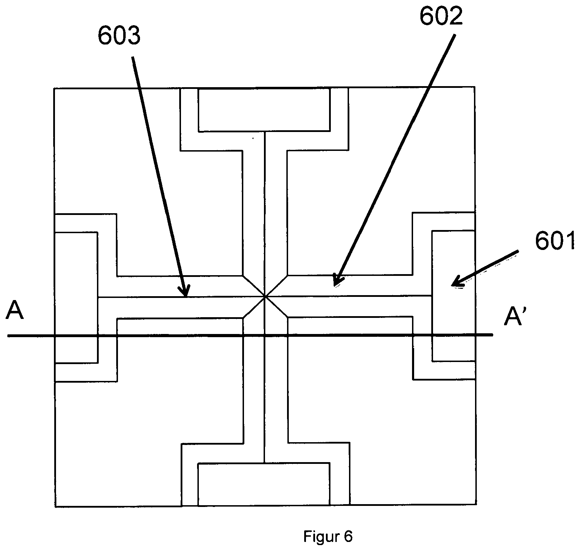

- Figur 6:: Aufsicht auf die aktive Siliziumschicht mit eingeätzten Nanodrähten.
- Figur 7:: Aufsicht auf den Feldeffekttransistor ohne Umrandung mit einem in der aktiven Siliziumschicht angeordneten quaderförmigen Metallkontakt.
- Figur 8:: Fläche des Musters mit Erläuterung der geometrischen Definitionen.
- Figur 9:: Maske mit Teilflächen des Musters aus den zwei diametral gegenüberliegenden Quadranten II und IV.
- Figur 10:: Maske mit Teilflächen des Musters aus den zwei diametral gegenüberliegenden Quadranten I und III.
- Figur 11:: Querschnitt durch die Schichtenfolge, aus welcher der erfindungsgemäße Feldeffekttransistor hergestellt wird.
- Figur 12:: Querschnitt durch die Schichtenfolge nach Entfernung ausgewählter Bereiche der PMMA-Schicht.
- Figur 13:: Querschnitt durch die Schichtenfolge nach Entfernung ausgewählter Bereiche der oberen Siliziumdioxidschicht.
- Figur 14:: Querschnitt durch die Schichtenfolge nach Entfernung der verbleibenden PMMA-Erhebungen.

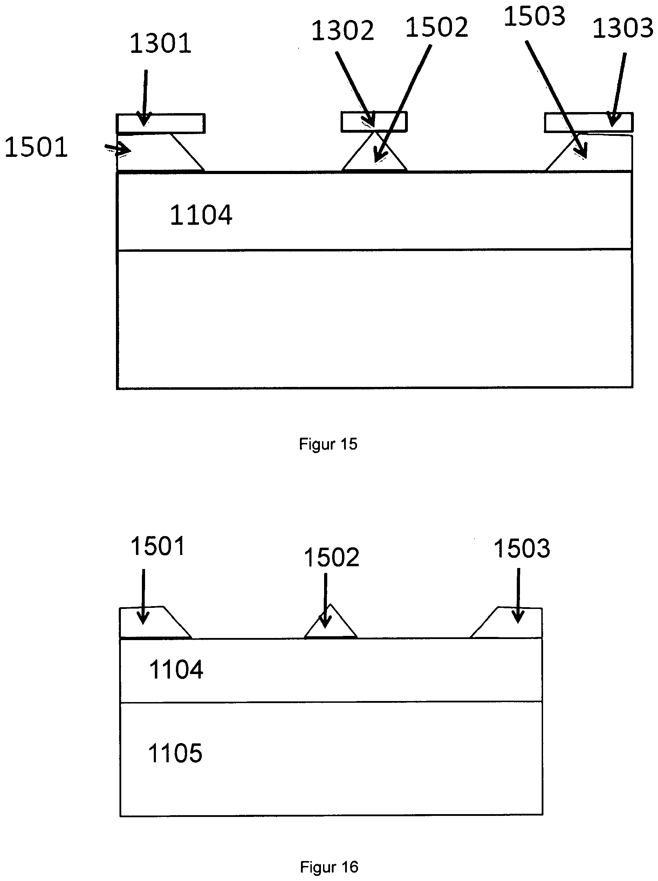

- Figur 15:: Querschnitt durch die Schichtenfolge nach Anordnung der gewünschten anisotropen Strukturen in der aktiven Siliziumschicht.
- Figur 16:: Querschnitt durch die Schichtenfolge nach Entfernung aller Bereiche der oberen Siliziumschicht.
- Figur 17:: Querschnitt durch die Schichtenfolge nach Anordnung einer neuen Siliziumdioxidschicht entlang der Oberfläche der Nanodrähte.
- Figur 18:: Querschnitt durch die Schichtenfolge nach Anordnung von Goldplättchen auf den Nanodrähten.
- Figur 19:: Querschnitt durch die Schichtenfolge nach Anordnung eines quaderförmigen Metallkontaktes.
- Figur 20:: Querschnitt durch die Schichtenfolge nach Entfernung eines geeigneten Bereichs der PMMA-Schicht
- Figur 21:: Querschnitt durch die Schichtenfolge nach Ätzung ausgewählter Bereiche in der Siliziumdioxidschicht, welche durch die in Figur 9 gezeigte Maske bestimmt werden.
- Figur 22:: Querschnitt durch die Schichtenfolge nach Ätzung ausgewählter Bereiche in der Siliziumdioxidschicht, welche durch die in Figur 10 gezeigte Maske bestimmt werden.
- Figur 23:: Querschnitt durch die Schichtenfolge nach Entfernung ausgewählter Bereiche der oberen Siliziumdioxidschicht.
- Figur 24:: Querschnitt durch die Schichtenfolge nach Entfernung aller Bereiche der PMMA-Schicht und der oberen Siliziumdioxidschicht.

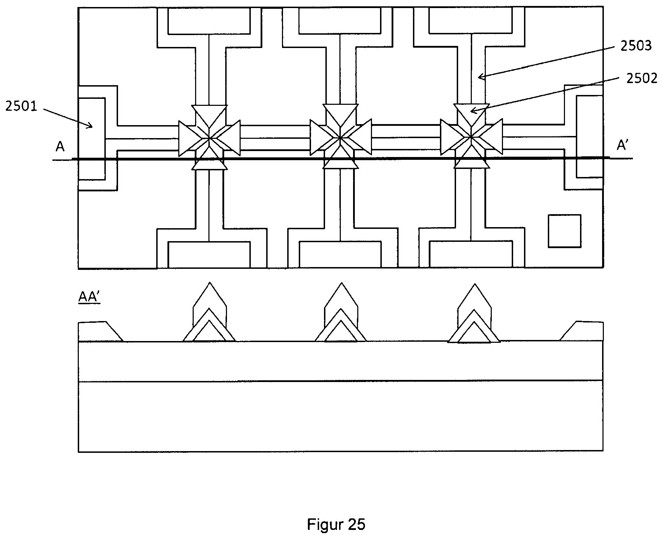

- Figur 25:: Netzwerk aus mehreren durch Nanodrähte verbundenen Kreuzungsbereichen.

Figur 1 zeigt den aktiven Bereich des Feldeffekttransistors mit zwei sich kreuezenden Nanodrähten. Figur 1 a) zeigt eine Seitenansicht. Hier ist der Fall dargestellt, dass sich zwei Nanodrähte 101, 102 mit dreieckigem Querschnitt in einem Winkel von 90° schneiden. Die charakteristische Breite des dreieckigen Querschnitts, mit L_{side} bezeichnet, also die Breite des Drahtes auf der dem Substrat (nicht dargestellt) zugewandten Seite, beträgt 50 nm. Die Länge des Nanodrahts L_{NW} nimmt z. B. Werte von 200 nm, 400 nm, 600 nm, 1000 nm oder einen Wert dazwischen an.

Figur 1 b) zeigt die Aufsicht auf die zwei Nanodrähte 101, 102, welche sich in einem Winkel von 90° in einem Kreuzungsbereich mit dem Zentrum 103 schneiden. Das Substrat des Silicon-on-Insulator kann mit einer Vorspannung beaufschlagt werden, der sogenannten back gate Spannung. Hierdurch wird der leitende Bereich des Nanodrahts, in dem Ladungsfluß stattfindet, an die Spitze, also der dem Substrat abgewandten Bereich, der gezeigten dreieckigen Struktur verschoben.

Figur 2 a) zeigt die Mesa-Struktur im Falle mehrerer Nanodrähte. Figur 2 b) zeigt den vergö-ßerten mittleren Bereich der Mesa-Struktur aus Figur 2 a) mit den Nanodrähten, die sich in einem Winkel von 90° schneiden, wobei zwei mal drei Kontaktpunkte vorliegen. Dargestellt wird die Struktur aus zwei Nanodrähten in der Horizontalen 219, 220 und drei Nanodrähten in der Vertikalen in der neuen Maske, welche mit 217, 218, 221 bezeichnet werden.

Jeder Nanodraht ist mit einer entsprechenden, in Figur 2 a) gezeigten Zuleitung 201, 202, 203, 204, 205, 206, 207, 208, 209, 210 verbunden. Diese Zuleitungen weisen Abmessungen auf der Skala von Mikrometern auf. Hierdurch kann die bei der optischen Lithographie typischerweise zur Verfügung stehende Auflösung verwendet werden. Die Lithographie kann in einem Schritt durchgeführt werden oder in mehreren Teilschritten.

Die schwarz gefärbte Fläche korrespondiert mit der Fläche aus Silizium. Es gibt hier zehn elektrische Kontakte zwischen den Zuleitungen und den jeweiligen Nanodrähten, von denen in Figur 2 b) beispielhaft vier mit 211, 212, 213, 214 gekennzeichnet sind. Von den zwei mal drei Kontaktpunkten, an denen sich die Nanodrähte kreuzen, sind beispeilhaft zwei mit 215 und 216 bezeichnet.

Figur 3 zeigt die Maske, welche entwickelt wurde, um den Feldeffekttransistor mit einer Struktur aus fünf sich kreuzenden Nanodrähten herzustellen, welche mit gleicher Höhe und auf der gleichen Ebene angeordnet sind. Die Figur zeigt ein Beispiel von zwei beziehungsweise drei Nanodrähten, welche sich bei 90° schneiden. Gezeigt sind auch die jeweiligen Zuleitungen. Das Quadrat 301 umfasst die Fläche, in welcher Elektronenstrahlen zur Strukturierung verwendet werden.

Figur 4 zeigt einen Feldeffekttransistor umfassend Nanodrähte 402 und 404 auf einer SiO₂ - Schicht 408, welche sich in einem Winkel von 90° im Kreuzungsbereich 405 kreuzen. An den Enden der Nanodrähte sind Source- und Drain-Kontakte angeordnet, zum Beispiel 406 und 403. Source und Drain umfassen jeweils eine obere Kontaktfläche aus einem Metall, beispielhaft gekennzeichnet mit 401. Die Kontakte sind durch eine Passivierungsschicht geschützt, hier bezeichnet mit 407. Diese Passivierungsschicht bildet auch eine flüssigkeitsdichte Umrandung. Gezeigt ist ferner ein grosser Metallkontakt 410 an der vorderen Seite der Struktur, um das Substrat 409 mit einer Spannung, beziehungsweise einer back gate Spannung, zu beaufschlagen.

Figur 5 zeigt die Aufsicht zweier Nanodrähte 502 und 507, welche sich in einem Winkel von 90° kreuzen, sowie die rechteckigen Metallkontakte 501, 504, 506, 508 an den Drähten und den Kreuzungsbereich 509 der Nanodrähte. Der Stromfluß in dem Kreuzungsbereich kann durch das Anlegen einer Spannung an das Substrat in die Spitze der Nanodrähte verschoben werden. Eine für die Untersuchung einer Probe geeignete Anlagerstelle kann ebenfalls durch Anlegen einer Spannung an das Substrat ausgewählt werden. Gezeigt ist auch eine bowtie-Antenne mit zwei dreieckigen Metallplättchen 503 und 505, welche nahe am Kreuzungsbereich der Nanodrähte angeordnet ist. Durch die Antenne kann die Dichte der Fallen beziehungsweise Anlagerstellen eingestellt und die Auswahl beziehungsweise Position einer einzelnen Anlagerstelle kontrolliert werden. Durch das Anlegen einer Spannung an das Substrat kann die geeignete Anlagerstelle beziehungsweise Falle ausgewählt werden, um das verstärkte Signal aus der Änderung des Oberflächenpotentials in dem Bereich der sich kreuzenden Nanodrähte zu erhalten. Die Änderung des Oberflächenpotentials ergibt sich aus der Bindung beziehungsweise Anlagerung von Molekülen an die dielektrische Schicht des Gates.

Figur 6 zeigt eine Aufsicht auf die aktive Siliziumschicht, mit den in diese Schicht geätzten Nanodrähten, von denen einer hier beispielhaft mit 602 bezeichnet wird mit dreieckigem Querschnitt, wobei die Spitze des dreieckigen Querschnitts entlang des Drahtes hier mit 603 bezeichnet wird und Erhebungen für die elektrischen Kontakte, von denen eine hier beispielhaft mit 601 bezeichnet wird.

Figur 7 zeigt eine Aufsicht auf den Feldeffekttransistor ohne Umrandung mit den Nanodrähten sowie einem in der aktiven Siliziumschicht angeordneten quaderförmigen Metallkontakt 701 zur Kontaktierung des Substrats.

Figur 8 zeigt die Fläche des Musters zur Anordnung der Nanodrähte mit den Quadranten I, II, III, IV, welche durch die Längs- beziehungsweise Symmetrieachsen 806, 807 der Fläche des Musters 801 begrenzt werden. Gezeigt werden ferner die zu der Fläche des Musters in den Quadranten komplementären Flächen, welche die Fläche des Musters in den jeweiligen Quadranten zu einem Quadrat ergänzen. Beispielhaft ist eine dieser komplementären Flächen mit 802 bezeichnet. Ferner wird beispielhaft eine Kante 805 als Teilstrecke zwischen den Eckpunkten 803 und 804 der Fläche des Musters gezeigt.

Figur 9 zeigt eine Maske, bei welcher die Teilflächen des Musters in den zwei diametral gegenüberliegenden Quadranten I und III durch weitere Flächen jeweils zu einem Quadrat ergänzt sind. In den Quadranten II und IV sind die Teilflächen des Musters nicht zu einem Quadrat ergänzt. So kann entlang der Kanten in diesen Quadranten, zum Beispiel durch die Fläche 902, Strahlung hindurchtreten.

Figur 10 zeigt die zu der Maske in Figur 9 komplementäre Maske. Bei dieser Maske sind die Teilflächen des Musters in den zwei diametral gegenüberliegenden Quadranten II und IV durch weitere Flächen jeweils zu einem Quadrat ergänzt. In den Quadranten I und III sind die Teilflächen des Musters nicht zu einem Quadrat ergänzt. So kann entlang der Kanten in diesen Quadranten, zum Beispiel durch die Fläche 1002, Strahlung hindurchtreten.

Figur 11 zeigt einen Querschnitt durch das Substrat, umfassend zum Beispiel eine PMMA-Schicht 1101, eine Siliziumdioxid-Schicht 1102, eine aktive Silizium-Schicht 1103, deren {1 0 0}-Ebene in Richtung der Normale der Oberfläche des Substrats in Richtung der Schichtenfolge orientiert ist, eine weitere Siliziumdioxid-Schicht 1104, eine Silizium-Schicht 1105.

Figur 12 zeigt die Schichtenfolge, nachdem mit Elektronenstrahlen mit Hilfe einer Maske gemäß Figur 8 ausgewählte Bereiche der PMMA-Schicht bestrahlt und durch einen dem Fachmann bekannten Entwicklungsschritt entfernt wurden. Es verbleiben PMMA-Erhebungen 1201, 1202, 1203 auf der Siliziumdioxid-Schicht 1102.

Figur 13 zeigt eine Schichtenfolge, nachdem mit resistivem lonenätzen (resistive ion etching: RIE) die Bereiche der Siliziumdioxidschicht 1102 zwischen den PMMA-Bereichen 1201, 1202, 1203 entfernt wurden. Es verbleiben die Bereiche 1301, 1302, 1303 der Siliziumdioxidschicht.

Figur 14 zeigt die Schichtenfolge, nachdem die verbleibenden PMMA-Erhebungen 1201, 1202, 1203 auf der Siliziumdioxid-Schicht durch dem Fachmann bekannte Methoden entfernt wurden.

Figur 15 zeigt die Schichtenfolge, nachdem in der aktiven Siliziumschicht die gewünschten anisotropen Strukturen 1501, 1502, 1503 unterhalb der verbleibenden Bereiche der Siliziumdioxidschicht 1301, 1302, 1303 hineingeätzt wurden.

Figur 16 zeigt die Schichtenfolge, nachdem die Bereiche der Siliziumdioxidschicht 1301, 1302, 1303 durch dem Fachmann bekannte Methoden entfernt wurden. Es verbleibt die gewünschte Geometrie mit einem im Querschnitt dreiecksförmigen Nanodraht 1502.

Figur 17 zeigt die Schichtenfolge, nachdem auf dem Nanodraht 1502 eine neue Siliziumdioxidschicht 1701 durch thermische Oxidation entlang der Oberfläche des Nanodrahtes angeordnet wurde.

Figur 18 zeigt die Schichtenfolge, nachdem auf die Silziumdioxidschicht 1701 auf dem Nanodraht mit dreieckigem Querschnitt 1502 ein Goldplättchen 1801 als Bestandteil der Antenne angeordnet wurde. An den Erhebungen 1501 und 1503 wurden außerdem Passiveriungselemente 1802 und 1803 angeordnet.

Figur 19 zeigt die Schichtenfolge entlang der in Figur 7 eingezeichneten Linie BB', nachdem in der aktiven Siliziumschicht ein quaderförmiger Metallkontakt 1904 angeordnet wurde, welcher mit der untersten Siliziumschicht 1105 zum Anlegen einer back gate Spannung in Kontakt steht. Im gezeigten Querschnitt wird die Siliziumdioxidschicht auf der untersten Siliziumschicht in zwei Bereiche 1906 und 1908 unterteilt. Auf der als Kontakt auf der Siliziumdioxidschicht angeordneten Erhebung 1907, welche Silizium umfaßt und die in der aktiven Siliziumschicht angeordnet ist, ist eine quaderförmige Erhebung 1902 umfassend Metall zur elektrischen Kontaktierung mit dem äußeren Messaufbau angeordnet. Das Element 1901 umfaßt passivierendes Material.

Figur 20 zeigt die Schichtenfolge entlang der in Figur 6 gezeigten Linie AA', nachdem ein geeigneter Bereich der PMMA-Schicht mit der in Figur 9 gezeigten Maske zunächst bestrahlt und dann entfernt wurde. Von der PMMA-Schicht verbleiben im Querschnitt die zwei Teilbereiche 2001 und 2002.

Figur 21 zeigt die Schichtenfolge, nachdem die Bereiche der Siliziumdioxidschicht 1102 unterhalb der in der PMMA-Schicht verbleibenden Bereiche 2001 und 2002 entfernt wurden, so dass zwei Teilbereiche 2101 und 2102 in dieser Schicht verbleiben und die Bereiche der aktiven Siliziumschicht 2103 und 2104 unterhalb dieser verbleibenden Bereiche 2101 und 2102 anisotrop angeätzt wurden.

Figur 22 zeigt die in Figur 21 genannte Schichtenfolge, nachdem der angeätzte Bereich durch Anordnung von neuem PMMA geschützt wurde und ein geeigneter Bereich der PMMA-Schicht mit der in Figur 10 gezeigten Maske zunächst bestrahlt und dann entfernt wurde. Von der PMMA-Schicht verbleiben im Querschnitt die zwei Teilbereich 2201 und 2202.

Figur 23 zeigt die vorgenannte Schichtenfolge, nachdem die Bereiche der Siliziumdioxidschicht 2101 unterhalb der in der PMMA-Schicht verbleibenden Bereiche 2201 und 2202 entfernt wurden, so dass zwei Teilbereiche 2301 und 2302 in dieser Schicht verbleiben und der Bereich der aktiven Siliziumschicht 2103 zwischen diesen Bereichen 2301 und 2302 anisotrop geätzt wurde, so dass die Teilbereiche 2303 und 2304 verbleiben. Hierbei bildet der Teilbereich 2304 den Nanodraht mit dreieckigem Querschnitt.

Figur 24 zeigt die Schichtenfolge, nachdem die Bereiche der PMMA- Schicht 2201, 2202 und der Siliziumdioxidschicht 2301, 2302, 2102 durch dem Fachmann bekannte Methoden entfernt wurden. Es verbleibt die gewünschte Geometrie mit einem im Querschnitt dreiecksförmigen Nanodraht 2304.

Figur 25 zeigt ein Netzwerk aus mehreren durch Nanodrähte verbundenen Kreuzungsbereichen. Von den verbindenden Nanodrähten ist einer beispielhaft mit 2503 und von den Kreuzungsbereichen einer beispielhaft mit 2502 bezeichnet. Von den Kontakten ist einer beispielhaft mit 2501 bezeichnet. Ein solches Netzwerk kann zum Beispiel in der Informationstechnologie oder Quanteninformationstechnologie für logische Gatter verwendet werden, wenn durch das Verhalten der Drainströme das Einfangen oder Abgeben von Ladungsträgern wie Elektronen durch die Störstellen gemessen wird.

Für die Ausführungsbeispiele gilt:
Obwohl in der einfachsten Ausführung der Erfindung von jeweils zwei sich kreuzenden Nanodrähten aus einem halbleitenden Material mit jeweils einem Source- und Drainkontakt und mit Mitteln zum Anlegen einer Spannung zwischen dem jeweiligen Source- und Darin Kontakt gesprochen wird, hat sich im Rahmen der Erfindung herausgestellt, dass es von Vorteil sein kann, wenn die beiden sich kreuzenden Nanodrähte lediglich jeweils zwei Kontakte aufweisen. Diese können müssen aber nicht zwingend als Source- und Drainkontakte ausgebildet sein.

## Patentansprüche

1. Vorrichtung zur Messung elektrischer Potentiale einer flüssigen Probe, umfassend mindestens einen Feldeffekttransistor mit Source, Drain und Gate, wobei
- die Vorrichtung ein Substrat (408, 409; 1104, 1105) und zur Ausbildung einer kreuzförmigen Struktur mindestens zwei auf diesem Substrat angeordnete sich kreuzende Nanodrähte (402, 404; 502, 507; 1502) aus halbleitendem Material mit jeweils einem Source- und Drain-Kontakt (403, 406) als Feldeffekttransistor und Mittel zum Anlegen einer Spannung zwischen dem jeweiligen Source- und Drain-Kontakt aufweist, wobei die beiden sich kreuzenden Nanodrähte derart angeordnet sind, dass sich ausschließlich ein Kreuzungspunkt (103; 405; 509) ergibt,
- die beiden Nanodrähte jeweils im Querschnitt die Form eines Dreiecks aufweisen und ihre Spitze sich in dem vom Substrat abgewandten Bereich befindet, wobei die sich kreuzenden Nanodrähte (402, 404; 502, 507; 1502) in der gleichen Ebene angeordnet sind,
- an dem Substrat (409) Mittel (410) zur Beaufschlagung des Substrats (409) mit einer Spannung angeordnet sind,
- die Nanodrähte (402, 404; 502, 507; 1502) durch eine dielektrische Schicht (1701) entlang ihrer Oberfläche mit einer Schichtdicke zwischen 5 und 40 nm mindestens gegen die flüssige Probe elektrisch isoliert sind und
- in dieser dielektrischen Schicht (1701) mindestens eine Störstelle als Anlagerstelle am Kreuzungspunkt (103; 405; 509) der beiden Nanodrähte (101, 102; 402, 404; 502, 507; 1502) angeordnet ist, welche Ladungsträger aus mindestens einem der beiden Nanodrähte einzufangen und umgekehrt an diesen Nanodraht abzugeben vermag.

2. Vorrichtung nach Anspruch 1,
**dadurch gekennzeichnet, dass**
auf der dielektrischen Schicht an jedem Nanodraht (502, 507) auf jeder Seite des jeweiligen Nanodrahts um den gemeinsamen Kreuzungsbereich (509) der Nanodrähte ein Plättchen (503, 505; 1801) aus Metall angeordnet ist, wobei gegenüberliegende Plättchen jeweils eine Antenne bilden.

3. Vorrichtung nach einem der vorherigen Ansprüche,
**dadurch gekennzeichnet, dass**
mindestens ein Abschnitt mindestens eines Nanodrahts eine andere Breite und/oder Höhe aufweist als der Rest dieses Nanodrahts.

4. Verfahren zur Herstellung einer Vorrichtung zur Messung elektrischer Potentiale einer flüssigen Probe, umfassend mindestens einen Feldeffekttransistor mit Source, Drain und Gate, mit den folgenden Schritten:
- auf einem Substrat (408, 409; 1104, 1105) wird eine halbleitende Schicht (1103) angeordnet,
- mit Hilfe einer Maske (301) mit kreuzförmiger Struktur werden in einem anisotropen Ätzprozess zur Ausbildung einer kreuzförmigen Struktur mindestens zwei sich kreuzende halbleitende Nanodrähte (402, 404; 502, 507; 1502) in der halbleitenden Schicht (1103) als Feldeffekttransistor angeordnet, wobei die beiden sich kreuzenden Nanodrähte derart angeordnet werden, dass sich ausschließlich ein Kreuzungspunkt (103; 405; 509) ergibt,
- wobei die beiden Nanodrähte jeweils im Querschnitt die Form eines Dreiecks aufweisen und ihre Spitzen in dem vom Substrat abgewandten Bereich in der gleichen Ebene angeordnet werden,
- es werden Source- und Drainkontakte (403, 406) an jedem Nanodraht angeordnet,
- an dem Substrat (409) werden Mittel (410) zur Beaufschlagung des Substrats mit einer Spannung angeordnet,
- auf der Oberfläche der Nanodrähte wird eine dielektrische Schicht (1701) mit einer Schichtdicke zwischen 5 und 40 nm angeordnet,
- in dieser dielektrischen Schicht (1701) wird mittels elektromagnetischer Strahlung mindestens eine Störstelle gezielt als Anlagerstelle am Kreuzungspunkt (103; 405; 509) der beiden Nanodrähte (101, 102; 402, 404; 502, 507; 1502) erzeugt, welche Ladungsträger aus mindestens einem der beiden Nanodrähte einzufangen und umgekehrt an diesen Nanodraht abzugeben vermag.

5. Verfahren nach Anspruch 4,
bei dem der anisotrope Ätzprozess mindestens zwei Ätzschritte unter Verwendung jeweils einer Maske in jedem Ätzschritt umfasst.

6. Verfahren nach einem der Ansprüche 4 bis 5,
**gekennzeichnet durch** die Schritte:
a) auf einem Substrat (409, 1105) wird zumindest eine halbleitende Schicht (1103) angeordnet,
b) ein Muster einer virtuellen oder physischen Maske (301), welches zwei entlang ihrer Längsachse achsensymmetrische Strukturen umfasst, die sich kreuzen und die jeweils mindestens eine insgesamt oder abschnittsweise rechteckige oder quadratische Form aufweisen, wird bereitgestellt,
c) es wird mindestens an einer Kante einer Fläche auf der halbleitenden Schicht, welche mit der Gesamtfläche des Musters deckungsgleich ist, Ätzmittel angeordnet, welches das Material der halbleitenden Schicht (1103) anisotrop ätzt,
d) der Schritt c) wird für gegenüberliegende Kanten des Randes der in Schritt c) genannten Fläche wiederholt bis mindestens zwei sich kreuzende Nanodrähte (402, 404; 502, 507; 1502) mit dreieckigem Querschnitt entlang der Längsachsen der Fläche angeordnet sind mit einer an jedem Ende des Nanodrahts angeordneten Erhebung für Source beziehungsweise Drain (403, 406),
e) entlang der Oberfläche der Nanodrähte wird eine dielektrische Schicht (1701) angeordnet,
f) in der dielektrischen Schicht (1701) entlang der Oberfläche der Drähte (402, 404; 502, 507; 1502) wird mindestens eine Anlagerstelle angeordnet,
g) die für Drain und Source bestimmten Erhebungen und das Substrat werden mit Mitteln (410) zur Beaufschlagung einer Spannung elektrisch leitend verbunden.

7. Verfahren nach Anspruch 6,
**dadurch gekennzeichnet, dass**
die Anordnung des Ätzmittels gemäß Schritt c) in den folgenden Teilschritten durchgeführt wird:
i) das Ätzmittel wird mindestens an einer ersten Kante der in Schritt c) genannten Fläche angeordnet, wobei mindestens zwischen der Längsachse dieser Fläche, die parallel zu der ersten Kante verläuft, und einer zweiten Kante, die der ersten Kante gegenüberliegt, kein Ätzmittel angeordnet wird,
ii) das Ätzmittel wird entfernt und anschließend mindestens an der zweiten Kante angeordnet, wobei mindestens zwischen der Längsachse aus Schritt i) und der ersten Kante kein Ätzmittel angeordnet wird,
iii) der Ätzprozess in den Schritten i) und ii) wird gemäß Schritt d) von Anspruch 6 durchgeführt.

8. Verfahren nach einem der Ansprüche 6 bis 7,
**dadurch gekennzeichnet, dass**
die Anordnung des Ätzmittels in Schritt c) in Anspruch 6 in folgenden Schritten durchgeführt wird:
i) auf der halbleitenden Schicht (1103) wird mindestens eine weitere Schicht (1102) angeordnet, welche ein Material umfasst, welches nach Bestrahlung mit Elektronenstrahlen und/oder Lichtstrahlen und/oder lonenstrahlen entfernt werden kann,
ii) es wird eine Maske (301) bereitgestellt, welche zumindest eine Fläche aufweist, die mit der Gesamtfläche des Musters übereinstimmt,
iii) die weitere Schicht (1102) wird mit Elektronenstrahlen und/oder Licht und/oder lonenstrahlen durch die Maske (301) bestrahlt,
iv) die Bereiche der weiteren Schicht (1102), welche durch die Maske hindurch bestrahlt wurden, werden entfernt,
v) das Ätzmittel wird zumindest auf der Oberfläche der halbleitenden Schicht (1103) auf der Fläche angeordnet, auf welcher die entfernten Bereiche der weiteren Schicht (1102) angeordnet waren,
vi) das Verfahren wird gemäß Schritt d) in Anspruch 6 fortgeführt, wobei das Ätzmittel an den Kanten der in Schritt c) genannten Fläche jeweils nach Verwendung einer Maske gemäß Schritt ii) angeordnet wird.

9. Verfahren nach Anspruch 8,
**dadurch gekennzeichnet, dass**
die bereitgestellte Maske jeweils die Gesamtfläche des Musters und zwei weitere Flächen umfasst, welche in diametral entgegengesetzten Quadranten, welche durch die beiden Längsachsen der Gesamtfläche des Musters begrenzt werden, angeordnet sind und zusammen mit der Teilfläche des Musters in dem jeweiligen Quadranten ein Quadrat oder Rechteck bilden.

10. Verfahren nach einem der Ansprüche 8 bis 9,
**dadurch gekennzeichnet, dass**
die bereitgestellte Maske jeweils die Gesamtfläche des Musters und drei weitere Flächen umfasst, welche in jeweils einem Quadranten, welche durch die beiden Längsachsen der Gesamtfläche des Musters begrenzt werden, angeordnet sind und zusammen mit der Teilfläche des Musters in dem jeweiligen Quadranten ein Quadrat oder Rechteck bilden.

11. Verfahren nach einem der Ansprüche 4 bis 10,
**dadurch gekennzeichnet, dass**
auf die dielektrische Schicht (1701) auf der Oberfläche jedes Nanodrahts (502, 507; 1502) Plättchen (503, 505; 1801) aus Metall aufgedampft werden.

12. Verfahren nach einem der Ansprüche 4 bis 11,
**dadurch gekennzeichnet, dass**
mindestens eine der rechteckigen Strukturen in dem Muster der verwendeten Maske in verschiedenen Abschnitten verschiedene Breiten aufweist.

13. Verwendung der Vorrichtung nach einem der Ansprüche 1 bis 3,
**dadurch gekennzeichnet,**
**dass** aus der Zeitkonstanten τ_{c} oder der Zeitkonstanten τₑ der pH-Wert der Probe ermittelt wird, wobei die Zeitkonstante τ_{c} das Zeitintervall ist, in welchem der Drainstrom den maximalen Wert annimmt, und die Zeitkonstante τₑ das Zeitintervall ist, in welchem der Drainstrom den minimalen Wert annimmt.

## Claims

1. A device for measuring electric potentials of a liquid sample, comprising at least one field effect transistor with source, drain and gate, wherein
- the device has a substrate (408, 409; 1104, 1105) and at least two crossing nanowires (402, 404; 502, 507; 1502) of semi-conducting material arranged on this substrate for forming a cross-shaped structure with a respective source and drain contact (403, 406) as a field effect transistor and means for applying a voltage between the respective source and drain contact, wherein the two crossing nanowires are arranged such that only one crossing point (103; 405; 509) results,
- the two nanowires, respectively in cross-section, have the shape of a triangle and their tip is located in the region facing away from the substrate, wherein the crossing nanowires (402, 404; 502, 507; 1502) are arranged in the same plane,
- means (410) for charging the substrate (409) with a voltage are arranged on the substrate (409),
- the nanowires (402, 404; 502, 507; 1502) are electrically isolated at least from the liquid sample by a dielectric layer (1701) along their surface with a layer thickness between 5 and 40 nm, and
- at least one disruption point is arranged in this dielectric layer (1701) as an anchoring point at the crossing point (103; 405; 509) of the two nanowires (101, 102; 402, 404; 502, 507; 1502) which is able to capture load carriers from at least one of the two nanowires and inversely deliver them to this nanowire.

2. The device according to claim 1,
**characterized in that**
a platelet (503, 505; 1801) of metal is arranged on the dielectric layer on every nanowire (502, 507) on each side of the respective nanowire about the common crossing region (509) of the nanowires, wherein opposite platelets respectively form an antenna.

3. The device according to any one of the preceding claims,
**characterized in that**
at least one section of at least one nanowire has another width and/or height than the rest of this nanowire.

4. A method for producing a device for measuring electric potentials of a liquid sample, comprising at least one field effect transistor with source, drain and gate, with the following steps:
- a semi-conducting layer (1103) is arranged on a substrate (408, 409; 1104, 1105),
- at least two crossing semi-conducting nanowires (402, 404; 502, 507; 1502) are arranged in the semi-conducting layer (1103) as a field effect transistor with the help of a mask (301) with a cross-shaped structure in an anisotropic etching process for forming a cross-shaped structure, wherein the two crossing nanowires are arranged such that only one crossing point (103; 405; 509) results,
- wherein the two nanowires, respectively in cross-section, have the shape of a triangle and their tips are arranged in the same plane in the region facing away from the substrate,
- source and drain contacts (403, 406) are arranged on each nanowire,
- means (410) for charging the substrate with a voltage are arranged on the substrate (409),
- a dielectric layer (1701) with a layer thickness between 5 and 40 nm is arranged on the surface of the nanowires,
- at least one disruption point is generated in a targeted manner as an anchoring point on the crossing point (103; 405; 509) of the two nanowires (101, 102; 402, 404; 502, 507; 1502) in this dielectric layer (1701) by means of electromagnetic radiation which is able to capture load carriers from at least one of the two nanowires and inversely deliver them to this nanowire.

5. The method according to claim 4,
wherein the anisotropic etching process comprises at least two etching steps using a respective mask in every etching step.

6. The method according to any one of claims 4 to 5,
**characterized by** the steps:
a) at least one semi-conducting layer (1103) is arranged on a substrate (409, 1105),
b) a pattern of a virtual or physical mask (301), which comprises two structures which are axis-symmetrical along their longitudinal axis, which cross and which respectively have at least one shape which is rectangular or squared in total or in sections, is provided,
c) etching means, which etches the material of the semi-conducting layer (1103) in an anisotropic manner, is arranged at least on one edge of an area on the semi-conducting layer which is congruent with the total area of the pattern,
d) step c) is repeated for opposite edges of the border of the area mentioned in step c) until at least two crossing nanowires (402, 404; 502, 507; 1502) are arranged with a triangular cross-section along the longitudinal axes of the area, with an elevation arranged at each end of the nanowire for source and drain (403, 406),
e) a dielectric layer (1701) is arranged along the surface of the nanowires,
f) at least one anchoring point is arranged in the dielectric layer (1701) along the surface of the wires (402, 404; 502, 507; 1502),
g) the elevations determined for drain and source and the substrate are connected in an electrically conducting manner with means (410) for charging with a voltage.

7. The method according to claim 6,
**characterized in that**
the arrangement of the etching means according to step c) is performed in the following sub-steps:
i) the etching means is arranged at least on one edge of the area mentioned in step c), wherein no etching means is arranged at least between the longitudinal axis of this area which runs parallel to the first edge and a second edge which is opposite to the first edge,
ii) the etching means is removed and subsequently arranged at least on the second edge, wherein no etching means is arranged at least between the longitudinal axis from step i) and the first edge,
iii) the etching process in steps i) and ii) is performed according to step d) of claim 6.

8. The method according to any one of claims 6 to 7,
**characterized in that**
the arrangement of the etching means in step c) in claim 6 is performed in the following steps:
i) at least one further layer (1102) which comprises a material which can be removed after radiation with electron beams and/or light beams and/or ion beams is arranged on the semi-conducting layer (1103),
ii) a mask (301) is provided which has at least one area which is congruent with the total area of the pattern,
iii) the further layer (1102) is radiated with electron beams and/or light and/or ion beams through the mask (301),
iv) the regions of the further layer (1102), which were radiated through the mask, are removed,
v) the etching means is arranged at least on the surface of the semi-conducting layer (1103) on the area on which the removed regions of the further layer (1102) were arranged,
vi) the method is continued according to step d) in claim 6, wherein the etching means is arranged on the edges of the area mentioned in step c) respectively after using a mask according to step ii).

9. The method according to claim 8,
**characterized in that**
the mask provided respectively comprises the total area of the pattern and two further areas which are arranged in diametrically opposite quadrants which are limited by the two longitudinal axes of the total area of the pattern and together with the partial area of the pattern in the respective quadrant form a square or a rectangle.

10. The method according to any one of claims 8 to 9,
**characterized in that**
the mask provided respectively comprises the total area of the pattern and three further areas which are arranged in respectively one quadrant which are limited by the two longitudinal axes of the total area of the pattern and together with the partial area of the pattern in the respective quadrant form a square or a rectangle.

11. The method according to any one of claims 4 to 10,
**characterized in that**
platelets (503, 505; 1801) of metal are vapor-deposited on the dielectric layer (1701) on the surface of each nanowire (502, 507; 1502).

12. The method according to any one of claims 4 to 11,
**characterized in that**
at least one of the rectangular structures in the pattern of the used mask has different widths in different sections.

13. Use of the device according to any one of claims 1 to 3,
**characterized in that**
the pH value of the sample is determined from the time constant τ_{c} or the time constant τₑ, wherein the time constant τ_{c} is the time interval in which the drain current takes on the maximum value and the time constant τₑ is the time interval in which the drain current takes on the minimum value.

## Revendications

1. Dispositif de mesure de potentiels électriques d'un échantillon liquide, comprenant au moins un transistor à effet de champ ayant source, drain et grille, dans lequel
- le dispositif a un substrat (408, 409 ; 1104, 1105) et, pour la formation d'une structure en forme de croix, au moins, disposés sur ce substrat, deux nanofils (402, 404 ; 502, 507 ; 1502), se croisant, en matériau semiconducteur, ayant chacun un contact (403, 406) de source et de drain comme transistor à effet de champ et des moyens d'application d'une tension entre le contact de source et de drain respectif, dans lequel les deux nanofils, se croisant, sont disposés de manière à donner exclusivement un point (103 ; 405 ; 509) de croisement,
- les deux nanofils ont chacun en section transversale la forme d'un triangle et sa pointe se trouve dans la partie, qui n'est pas tournée vers le substrat, dans lequel les nanofils (402, 404 ; 502, 507 ; 1502), se croisant sont disposés dans le même plan,
- sur le substrat (409) sont disposés des moyens (410) d'application d'une tension au substrat (409),
- les nanofils (402, 404 ; 502, 507 ; 1502) sont isolés électriquement, au moins à l'encontre de l'échantillon liquide, par une couche (1701) diélectrique, le long de leur surface, d'une épaisseur de couche comprise entre 5 et 40 nm et
- dans cette couche (1701) diélectrique est disposé au moins un endroit d'imperfection comme endroit de dépôt au point (103 ; 405 ; 509) de croisement des deux nanofils (101, 102 ; 402 , 404 ; 502, 507 ; 1502), qui permet de capter des porteurs de charge d'au moins l'un des deux nanofils et inversement d'en céder à ce nanofil.

2. Dispositif suivant la revendication 1,
**caractérisé en ce que**,
sur la couche diélectrique, est disposé, sur chaque nanofil (502, 507) de chaque côté du nanofil respectif, autour de la partie (509) de croisement commune des nanofils, une plaquette (503, 505 ; 1801) en métal, dans lequel des plaquettes se faisant face forment respectivement une antenne.

3. Dispositif suivant l'une des revendications précédentes,
**caractérisé en ce qu'**
au moins un tronçon d'au moins un nanofil a une largeur et/ou une hauteur autre que le reste de ce nanofil.

4. Procédé de fabrication d'un dispositif de mesure de potentiels électriques d'un échantillon liquide, comprenant au moins un transistor à effet de champ ayant source, drain et grille,
comprenant les stades suivants :
- on met une couche (1103) semiconductrice sur un substrat (408, 409 ; 1104, 1105),
- à l'aide du masque (301) de structure en forme de croix, on met, comme transistor à effet de champ dans un processus d'attaque chimique anisotrope pour la constitution d'une structure en croix, au moins deux nanofils (402, 404 ; 502, 507 ; 1502) semiconducteurs, se croisant, dans la couche (1103) semiconductrice, dans lequel on dispose les deux nanofils, se croisant, de manière à donner exclusivement un point (103 ; 405 ; 509) de croisement,
- dans lequel les deux nanofils ont chacun, en section transversale, la forme d'un triangle et on met leur pointe dans le même plan dans la partie, qui n'est pas tournée vers le substrat,
- on met des contacts (403, 406) de source et de drain sur chaque nanofil,
- on dispose, sur le substrat (409), des moyens (410) d'application d'une tension au substrat,
- on met, sur la surface des nanofils, une couche (1701) diélectrique d'une épaisseur de couche comprise entre 5 et 40 nm,
- on produit, dans cette couche (1701) diélectrique, au moyen du rayonnement électromagnétique, au moins un endroit d'imperfection ciblé comme endroit de dépôt au point (103 ; 405 ; 509) de croisement des deux nanofils (101, 102 ; 402, 404 ; 502, 507 ; 1502), qui permet de capter des porteurs de charge d'au moins l'un des deux nanofils et inversement d'en céder à ce nanofil.

5. Procédé suivant la revendication 4,
dans lequel l'opération d'attaque anisotrope comprend au moins deux stades d'attaque chimique en utilisant respectivement un masque dans chaque stade d'attaque chimique.

6. Procédé suivant l'une des revendications 4 à 5,
**caractérisé par** les stades :
a) on met au moins une couche (1103) semiconductrice sur un substrat (409, 1105),
b) on se procure un motif d'un masque (301) virtuel ou physique, qui comprend deux structures à symétrie axiale le long de son axe longitudinal, qui se croisent et qui ont chacune au moins une forme dans l'ensemble ou par endroits rectangulaire ou carrée,
c) on met, au moins sur une arête d'une surface sur la couche semiconductrice, qui coïncide avec toute la surface du motif, un agent d'attaque chimique, qui attaque de manière anisotrope le matériau de la couche (1103) semiconductrice,
d) on répète le stade c) pour des arêtes opposées du bord de la surface mentionnée au stade c), jusqu'à ce qu'au moins deux nanofils (402, 404 ; 502, 507 ; 1502), se croisant, de section transversale triangulaire, soient disposés le long des axes longitudinaux de la surface et avec une bosse pour une source et respectivement un drain (403 ; 406) disposée à chaque extrémité du nanofil,
e) on met une couche (1701) diélectrique le long de la surface des nanofils,
f) on met au moins un endroit de dépôt dans la couche (1701) diélectrique le long de la surface des fils (402, 404 ; 502, 507 ; 1502),
g) on reconnecte, d'une manière conductrice de l'électricité, les bosses destinées au drain et à la source et le substrat par des moyens (410) d'application d'une tension.

7. Procédé suivant la revendication 6,
**caractérisé en ce que**
l'on effectue la mise en place de l'agent d'attaque chimique suivant le stade c) dans les stades partiels suivants :
i) on met l'agent d'attaque chimique au moins sur une première arête de la surface mentionnée au stade c), dans lequel on ne met pas d'agent d'attaque chimique au moins entre l'axe longitudinal de cette surface, qui est parallèle à la première arête, et une deuxième arête, qui est en face de la première arête,
ii) on élimine l'agent d'attaque chimique et on en met ensuite au moins sur la deuxième arête, dans lequel on ne met pas d'agent d'attaque chimique au moins entre l'axe longitudinal du stade i) et la première arête,
iii) on effectue l'opération d'attaque chimique des stades i) et ii) suivant le stade d) de la revendication 6.

8. Procédé suivant l'une des revendications 6 à 7,
**caractérisé en ce que**
l'on effectue la mise en position de l'agent d'attaque chimique au stade c) de la revendication 6 en les stades suivants :
i) on met, sur la couche (1103) semiconductrice au moins une autre couche (1102), qui comprend un matériau, qui peut être éliminé après exposition à des faisceaux d'électrons et/ou des faisceaux lumineux et/ou des faisceaux d'ions,
ii) on se procure (301), qui a au moins une surface, qui coïncide avec la surface totale du motif,
iii) on soumet l'autre couche (1102) à des faisceaux d'électrons et/ou à de la lumière et/ou à des faisceaux d'ions à travers le masque (301),
iv) on élimine les parties de l'autre couche (1102), qui ont été exposées à travers le masque,
v) on met l'agent d'attaque chimique au moins sur la surface de la couche (1103) semiconductrice, sur la surface sur laquelle étaient disposées les parties éliminées de l'autre couche (1102),
vi) on continue le procédé suivant le stade d) de la revendication 6, dans lequel on met l'agent d'attaque chimique sur les arêtes de la surface mentionnée au stade c) respectivement après utilisation d'un masque suivant le stade ii).

9. Procédé suivant la revendication 8,
**caractérisé en ce que**
le masque que l'on s'est procuré comprend respectivement la surface totale du motif et deux autres surfaces, qui sont disposées dans des cadrans opposés diamétralement, qui sont délimités par les deux axes longitudinaux de la surface totale du motif et qui forment ensemble avec la surface partielle du motif dans le cadran respectif un carré ou un rectangle.

10. Procédé suivant l'une des revendications 8 à 9,
**caractérisé en ce que**
le masque que l'on s'est procuré comprend respectivement la surface totale du motif et trois autres surfaces, qui sont disposées dans respectivement un cadran, qui sont délimitées par les deux axes longitudinaux de la surface totale du motif et qui forment ensemble avec la surface partielle du motif dans le cadran respectif un carré ou un rectangle.

11. Procédé suivant l'une des revendications 4 à 10,
**caractérisé en ce que**
on dépose, par évaporation sur la couche (1701) diélectrique sur la surface de chaque nanofil (502, 507 ; 1502) des plaquettes (503, 505 ; 1801) en métal.

12. Procédé suivant l'une des revendications 4 à 11,
**caractérisé en ce qu'**
au moins l'une des structures rectangulaires du motif du masque utilisé a des largeurs différentes dans des parties différentes.

13. Utilisation du dispositif suivant l'une des revendications 1 à 3,
**caractérisée en ce que**
l'on détermine, à partir de la constante de temps τ_{c} ou de la constante de temps τₑ, le pH de l'échantillon, dans lequel la constante de temps τ_{c} est l'intervalle de temps, dans lequel le courant de drain prend la valeur maximum, et la constante de temps τₑ est l'intervalle de temps, dans lequel le courant de drain prend la valeur minimum.
